# EUROPEAN PATENT APPLICATION

(11) **EP 1 511 268 A2**
(43) Date of publication of application: **02.03.2005**
(21) Application number: 04010791.4
(22) Date of filing: 06.05.2004
(51) Int. Cl.: H04L 29/06, H04L 12/28

(54) **System for processing unprocessed messages after a restart in a home network**

(30) Priority: 08.05.2003 JP 2003130695; 08.05.2003 JP 2003130696
(71) Applicant: MATSUSHITA ELECTRIC INDUSTRIAL CO., LTD., Kadoma-shi, Osaka 571-8501 (JP)
(72) Inventor: Katano, Toshiaki, Amagasaki-shi Hyogo (JP); Nagoshi, Yukiko, Moriguchi-shi Osaka (JP); Takubo, Hidetoshi, Toyonaka-shi Osaka (JP)
(74) Representative: Böckelen, Rainer

(57) **Abstract**

A message 6 received or created in a message generating section 10 is stored in a message memory 3. Upon lapse of a stand-by time, a message processing section 15 reads out the message 6 from the message memory 3 for transmission to an external device or for an internal process. When the transmission or the internal process is completed, an ID code attaching section 18 attaches a code indicating that the message 6 has been processed, to the message 6. A database stored in a discrimination database memory 4 describes an effective term with respect to each of contents of the message 6. In response to receiving a restart signal 8 after the operation of an apparatus controlling device 100 is suspended, a message discriminating section 20 causes the message processing section 15 to process the message which has not been processed and whose effective term has not lapsed, among the message(s) 6 stored in the message memory 3. With this arrangement, a proper process is executable with respect to the message which has been left unprocessed by the suspension of the operation of the apparatus controlling device 100, after the operation of the apparatus controlling device 100 is resumed.

## Description

### BACKGROUND OF THE INVENTION

### 1. Field of the Invention

The present invention relates to a message processor of implementing a process by communicating a message with an external device, an apparatus controlling device, a home appliance, a program for the message processor, a microcomputer system, a program for the microcomputer system, and a program product.

### 2. Description of the Related Art

There is a demand not only for infrastructure of communications at home, namely, a so-called "home network", in which high-speed and large-volume data transmission such as video transmission is required, but also for a relatively low-speed, small-volume, inexpensive facility network which is applicable to a variety of so-called "white goods" home appliances and accommodation-related equipment. For the purpose of facilitating construction of the latter network, ECHONET standards have been established by ECHONET consortium (see "ECHONET Standards Version 2.11" by ECHONET consortium, the contents are uploaded in §1-1 "Overview of ECHONET" Part 1 at URL: http://www.echonet.gr.jp, hereinafter, called as "D1"). In the home network including the facility network such as ECHONET standards, similarly to the other local area network (LAN), the Internet or the like, information is communicated between respective components communicatively connected with the network, unit by unit, by a format based on protocol inherent to the network. The unit of information to be sent to the network at one time is called a packet. On the other hand, the unit of information containing a certain meaning is called a message. The message can be conveyed by either one or plural packets.

Electrical apparatuses that are supposed to be primarily used at home are called as "home appliances", and among such home appliances, electrical apparatuses which are specifically connected with the network for communication of information are called as "information appliances". In such information appliances, there is known an appliance in which organic control operation with respect to the entirety of the information appliance, and communications with an external network are realized by exchanging messages between plural microcomputers (hereinafter, called as "sub microcomputers") individually in charge of controls of the respective components of the home appliance, and a microcomputer (hereinafter, called as "master microcomputer") of coordinating operations of the sub microcomputers.

In the information appliances, there is a case that the operation of a microcomputer is suspended is by occurrence of trouble of a hardware, or the like. To solve such a problem, there is known a technology disclosed in Japanese Unexamined Patent Publication No. 2001-280777 (hereinafter, called as "D2"). In the publication, the operation of an apparatus controlling device of a home appliance such as a refrigerator is resumed by allowing a user to manipulate a recovery switch when the operation of the apparatus controlling device is suspended.

Despite the above measures, the apparatus controlling device is brought to a state where a message is left unprocessed in the apparatus controlling device while the operation of the apparatus controlling device is suspended. Therefore, D2 fails to provide means for properly processing the message which has been left unprocessed by suspension of the operation of the apparatus controlling device, after restart of the apparatus controlling device.

### SUMMARY OF THE INVENTION

In view of the above, it is an object of the present invention to overcome the problems residing in the prior art. It is another object of the present invention to provide a message processor, an apparatus controlling device, a home appliance, a program for the message processor, a microcomputer, a program for the microcomputer, and a program product that enable to properly process a message that has been left unprocessed in the apparatus controlling device or in the microcomputer by suspension of the operation of the apparatus controlling device of the microcomputer, after restart of the apparatus controlling device or the microcomputer.

A message processor according to an aspect of the present invention implements a process by communicating a message with an external device. The message processor comprises: message generating means including at least one of message receiving means to receive the message from the external device, and message creating means to create the message; message storing means to store the message received or created by the message generating means; message processing means to read out the message stored in the message storing means and to implement a process based on the message; identification (ID) code attaching means to record, in the message storing means, the message processed by the message processing means with an ID code indicating that the message has been processed being attached thereto; discrimination database storing means to store a database describing an effective term with respect to each of contents of the message; and message discriminating means to read out the message from the message storing means in response to a restart signal received in the message processor after the operation of the message processor is suspended, and to cause the message processing means to implement the process with respect to the message to which the ID code has not been attached and whose effective term has not lapsed, among the readout message, by referring to the database.

These and other objects, features and advantages of the present invention will become more apparent upon reading of the following detailed description along with the accompanying drawings.

### BRIEF DESCRIPTION OF THE DRAWINGS

FIG. 1 is a block diagram showing a hardware configuration of a message processor in accordance with an embodiment of the present invention.
FIG. 2 is a block diagram depicted based on a function of the message processor.
FIG. 3 is a block diagram showing a hardware configuration of an apparatus controlling device in accordance with a first embodiment of the present invention.
FIG. 4 is a block diagram depicted based on a function of the apparatus controlling device in accordance with the first embodiment of the present invention.
FIG. 5 is an illustration showing contents of a message to be handled by the apparatus controlling device in accordance with the first embodiment of the present invention.
FIG. 6 is a flowchart showing an operation procedure of a communicating section in accordance with the first embodiment of the present invention.
FIG. 7 is an illustration showing a relation between generation of the message to be handled in the communicating section and a process of the message in accordance with the first embodiment of the present invention.
FIG. 8 is an illustration showing a data structure of the message in accordance with the first embodiment of the present invention.
FIG. 9 is a flowchart showing an operation procedure of the communicating section in accordance with the first embodiment of the present invention.
FIG. 10 is an illustration showing an example of a database stored in a database memory in accordance with the first embodiment of the present invention.
FIG. 11 is a flowchart showing a procedure regarding judgment as to whether a remaining message is to be processed, and a process of the message in accordance with the first embodiment of the present invention.
FIG. 12 is a block diagram showing a hardware configuration of an apparatus controlling device in accordance with a second embodiment of the present invention.
FIG. 13 is a block diagram depicted based on a function of the apparatus controlling device in accordance with the second embodiment of the present invention.
FIG. 14 is a flowchart showing an operation procedure of a controlling section in accordance with the second embodiment of the present invention.
FIG. 15 is an illustration showing an example of a database stored in a database memory in accordance with the second embodiment of the present invention.
FIG. 16 is a block diagram showing a hardware configuration of an apparatus controlling device in accordance with a third embodiment of the present invention.
FIG. 17 is a block diagram showing a hardware configuration of a modified apparatus controlling device in the present invention.
FIG. 18 is a flowchart showing an operation procedure of the modified apparatus controlling device.
FIG. 19 is an illustration showing a hardware configuration of a microcomputer system in accordance with a fourth embodiment of the present invention.
FIG. 20 is an illustration showing a hardware configuration of each microcomputer in accordance with the fourth embodiment of the present invention.
FIG. 21 is a block diagram showing a function of the microcomputer system in accordance with the fourth embodiment of the present invention.
FIG. 22 is a flowchart showing a flow of an ordinary process of the microcomputer system in accordance with the fourth embodiment of the present invention.
FIG. 23 is an illustration showing a data structure of a message in accordance with the fourth embodiment of the present invention.
FIG. 24 is a flowchart showing a process of the microcomputer system after a master microcomputer is restarted in accordance with the fourth embodiment of the present invention.
FIG. 25 is an illustration showing an example of contents of a database in accordance with the fourth embodiment of the present invention.
FIG. 26 is a flowchart showing a process of Step S328 in FIG. 24.
FIG. 27 is an illustration showing an example of the contents of the database in accordance with the fourth embodiment of the present invention.
FIG. 28 is an illustration showing an example of the contents of the database in accordance with the fourth embodiment of the present invention.
FIG. 29 is a flowchart showing a process of Step S330 in FIG. 24.
FIG. 30 is a flowchart showing an altered process of Step S330 in FIG. 24.
FIG. 31 is a flowchart showing a process of the microcomputer system after restart of a sub microcomputer as a recipient in accordance with the fourth embodiment of the present invention.
FIG. 32 is a block diagram showing an example of an arrangement of monitoring suspension of the operation of the microcomputer in accordance with the fourth embodiment of the present invention.
FIG. 33 is a block diagram showing an example of an altered arrangement of monitoring suspension of the operation of the microcomputer in accordance with the fourth embodiment of the present invention.
FIG. 34 is a block diagram showing an example of a further altered arrangement of monitoring suspension of the operation of the microcomputer in accordance with the fourth embodiment of the present invention.
FIG. 35 is a block diagram showing a function of a microcomputer system in accordance with a fifth embodiment of the present invention.
FIG. 36 is a flowchart showing a flow of an ordinary process of the microcomputer system in accordance with the fifth embodiment of the present invention.
FIG. 37 is a flowchart showing a process of the microcomputer system after restart of a sub microcomputer as a sender in accordance with the fifth embodiment of the present invention.
FIG. 38 is a flowchart showing a process of Step S370 in FIG. 37.
FIG. 39 is a block diagram showing a function of a microcomputer system in accordance with a sixth embodiment of the present invention.
FIG. 40 is a flowchart showing a flow of an ordinary process of the microcomputer system in accordance with the sixth embodiment of the present invention.
FIG. 41 is an illustration showing an example of a database stored in a database memory in accordance with the seventh embodiment of the present invention.
FIG. 42 is an illustration showing another example of a database stored in a database memory in accordance with the seventh embodiment of the present invention.
FIG. 43 is an illustration showing a data structure of the message in accordance with the seventh embodiment of the present invention.

### DETAILED DESCRIPTION OF THE PREFERRED EMBODIMENTS

### [Schematic configuration of first to third embodiments]

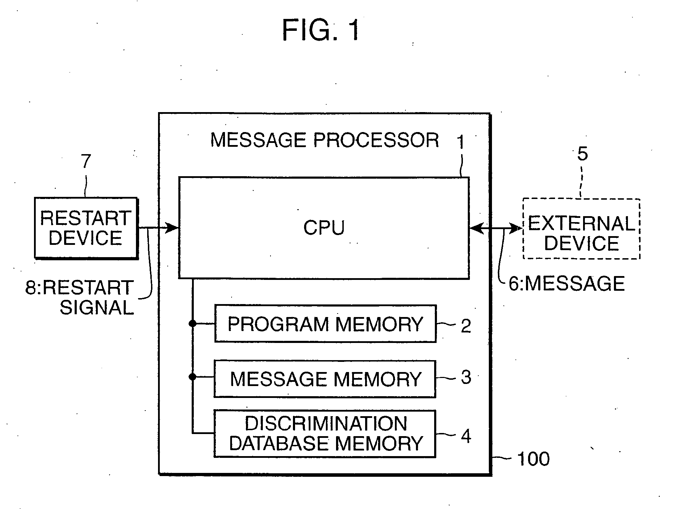

FIG. 1 is a block diagram showing a hardware configuration of a message processor according to an embodiment of the present invention. The message processor 100 is a device for implementing a process by communicating a message with an external device. A communicating section or a controlling section of an apparatus controlling device, which will be described later, corresponds to a preferred embodiment of the message processor 100.

The message processor 100 includes a CPU 1, a program memory 2, a message memory (message storage) 3, and a discrimination database memory (discrimination database storage) 4. The CPU 1 communicates a message 6 with the external device 5, and implements various processes by cooperation with the message memory 3 and the discrimination database memory 4. The program memory 2 stores a program which defines operations of the CPU 1. The message memory 3 stores a received message 6 or a created message 6. The discrimination database memory 4 stores a database providing judgment criteria as to whether an unprocessed message 6 left in the message memory 3 be processed when the CPU 1 is restarted, in response to a restart signal 8 sent from an external restart device when the operation of the CPU 1 is suspended. Both the message memory 3 and the discrimination database memory 4 are allocated with an address in which the stored content is un-erasable in association with restarting of the CPU 1. This arrangement makes it possible to keep the message 6 stored in the message memory 3 and the database stored in the discrimination database memory 4 from being erased in association with restart of the CPU 1.

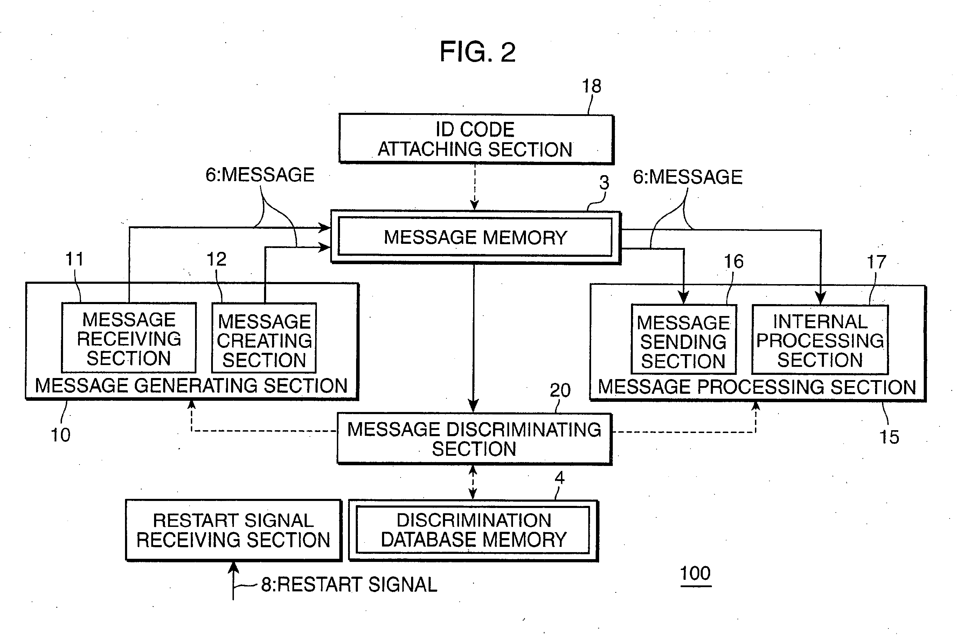

FIG. 2 is a block diagram depicted based on a function of the message processor 100. The message processor 100 shown in the example of FIG. 2 is realized by cooperation with the message memory 3 and the discrimination database memory 4. The message processor 100 shown in the example of FIG. 2 may be constructed by a hardware which requires no program.

Detailed functions of the respective elements of the message processor 100 will be described in the following description on preferred embodiments of the respective elements. In this section, the functions of the respective elements of the message processor 100 are briefly described.

A message receiving section 11 is for receiving the message 6 sent from the external device. A message creating section 12 is for creating the message 6. A message generating section 10 is provided with at least one of the message receiving section 11 and the message creating section 12. The message 6 received in the message generating section 10, or the message 6 created in the message creating section 12 is stored in the message memory 3. A message sending section 16 is for reading out the message 6 stored in the message memory 3 and sending the message 6 to the external device. An internal processing section 17 is for reading out the message 6 stored in the message memory 3, and implementing an internal process, for example, control of the apparatus, based on the read-out message 6.

Examples of generation and processing of the message 6 include an internal process such as transmission of the created message 6 to the external device 5, transmission of the received message 6 to the external device 5, and control of the apparatus based on the received message 6. In view of this, in the case where the message generating section 10 is provided with the message receiving section 11, a message processing section 15 is provided with at least one of the message sending section 16 and the internal processing section 17. In case that the message generating section 10 is provided with the message creating section 12, the message processing section 15 is provided with the message sending section 16. Alternatively, the message processing section 15 may be provided with both the message sending section 16 and the internal processing section 17 to selectively allow the process to be done depending on the contents of the message 6.

The CPU 1 is for implementing various processes. Normally, a stand-by time is generated until the message processing section 15 reads out the message from the message memory 3 after the message 6 is stored in the message memory 3. Accordingly, if the operation of the CPU 1 is suspended, the message 6 is left unprocessed in the message memory 3 because the stand-by time has not lapsed. In such a case, the message processor 100 implements the following process regarding the unprocessed message 6. It should be noted that the operation of the message processor 100 including the message memory 3 and the discrimination database memory 4 is suspended in case that the operation of the CPU 1 is suspended.

An identification (ID) code attaching section 18 is for recording the message 6 in the message memory 3 with an ID code representing that the message 6 has been processed being attached thereto when the process by the message processing section 15 is completed. The database stored in the discrimination database memory 4 describes a term that is significant in processing with respect to each of the contents of the message 6, namely, an effective term. A message discriminating section 20 is for reading out the message 6 from the message memory 3, in response to the restart signal 8 sent from the external device after the operation of the CPU 1 is suspended, and causing the message processing section 15 to process the message 6 to which the ID code has not been attached and whose effective term has not lapsed, among the readout message, by referring to the database. The thus constructed message processor 100 enables to process the message 6 that has been left unprocessed during suspension of the operation of the CPU 1, after restart of the CPU 1, and also enables to save time for processing an unprocessed message whose effective term has lapsed.

### [First Embodiment]

### (Schematic description of apparatus controlling device)

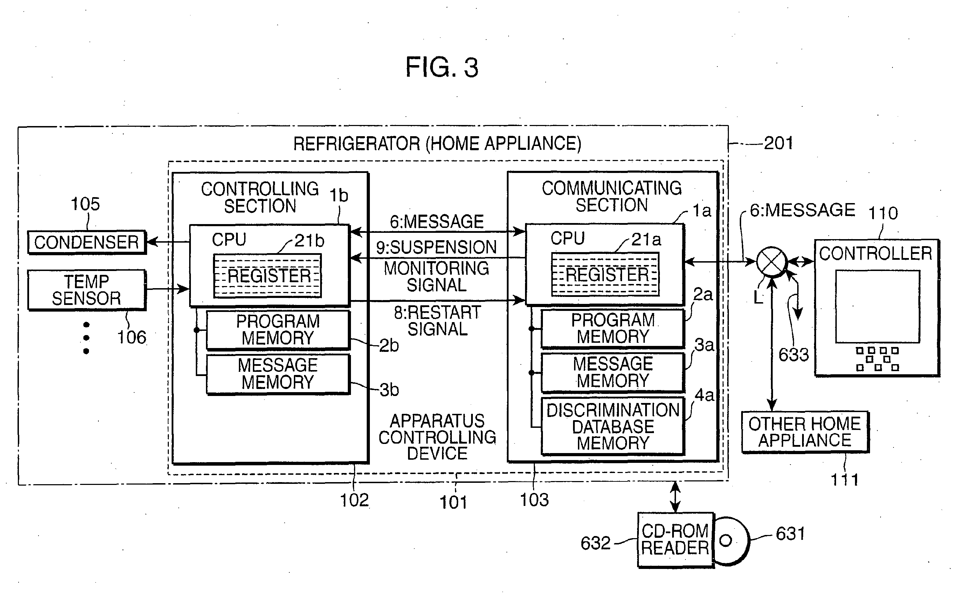

FIG. 3 is a block diagram showing a hardware configuration of an apparatus controlling device in accordance with a first embodiment of the present invention. The following is an example in which the apparatus controlling device 101 is applied to a refrigerator 201.

The apparatus controlling device 101 includes the controlling section 102 and the communicating section 103. The controlling section 102 controls a condenser 105, a temperature sensor 106, and other devices by communicating the message 6 with a controller 110 and other home appliance 111 via a communications line L. The communicating section 103 is a component which is provided between the controlling section 102 and the communications line L and which primarily implements protocol conversion of the message 6 to interface with the controlling section 102 and the communications line L. In the apparatus controlling device 101, the communicating section 103 corresponds to an example of the message processor 100. The communications line L is, for example, a facility network, based on ECHONET standards. A communication medium of the communications line L may be a wire or wireless. As an example of the wireless medium, a specific small-power wireless or Bluetooth® technology may be applicable. Communications within the apparatus controlling device 101 may not comply with ECHONET standards even if the communications line L be configured in compliance with ECHONET standards.

The communicating section 103 includes a CPU 1a, a program memory 2a, a message memory (message storage) 3a, and a discrimination database memory (discrimination database storage) 4a. These elements 1a, 2a, 3a, and 4a respectively correspond to examples of the CPU 1, the program memory 2, the message memory 3, and the discrimination database memory 4 in the message processor 100 (see FIG. 1). Specifically, the CPU 1a communicates the message 6 with the communications line L and with the controlling section 102, and implements various processes by cooperation with the message memory 3a and the discrimination database memory 4a. The program memory 2a stores a program that defines the operations of the CPU 1a. The message memory 3a stores a received message 6 or a created message 6. The discrimination database memory 4a stores a database describing judgment criteria as to whether the unprocessed message 6 remaining in the message memory 3a is to be processed when the operation of the CPU 1a is restarted, in response to a restart signal 8 sent from the controlling section 102 when the operation of the CPU 1a is suspended. Both the message memory 3a and the discrimination database memory 4a are allocated with an address in which the stored contents are un-erasable in association with restart of the CPU 1a. The operation of the CPU 1a may be suspended owing to an erroneous transmission of the message 6 through the communications line L or a process in the apparatus controlling device 101.

The controlling section 102 includes a CPU 1b, a program memory 2b, and a message memory (message storage) 3b. The CPU 1b communicates the message 6 with the communicating section 103, and implements various processes including control of the condenser 105 and the temperature sensor 106 by cooperation with the message memory 3b. The program memory 2b stores a program that defines the operations of the CPU 1b. The message memory 3b stores a received message 6 or a created message 6.

The CPU 1b has a function of restarting the operation of the CPU 1a when the operation of the CPU 1a is suspended. The CPU 1b receives a suspension monitoring signal 9 that is sent from the CPU 1a periodically, e.g. every 100 ms. If the CPU 1b fails to receive the suspension monitoring signal 9 for a certain duration, e.g. 1 second, the CPU 1b judges that the operation of the CPU 1a is suspended, and sends a restart signal 8 to the CPU 1a. Thereupon, the operation of the communicating section 103 is automatically resumed after temporarily suspending its operation.

The CPU 1a has a register 21a, and the CPU 1b has a register 21b. Operations of the registers 21a and 21b will be described later.

The program that defines the operations of the CPU 1a and the CPU 1b may be supplied through a recording medium 631 including an ROM, a flexible disc, and a CD-ROM, or may be supplied through a transmission medium 633 (including the communications line L) such as a telephone line and a network. FIG. 3 shows a CD-ROM as an example of the recording medium 631, and a telephone line as an example of the transmission medium 633. The communications line L may be a telephone line. The program recorded in the CD-ROM can be read out therefrom by connecting a CD-ROM reader 632 as an external device of the refrigerator 201 with an interface (not shown) or the like for storage in the program memories 2a, 2b. In the case where a software and data are supplied in the form of an ROM as an example of the recording medium 631, the apparatus controlling device 101 can execute the process in accordance with the program by installing the ROM serving as the program memories 2a, 2b in the apparatus controlling device. The program to be supplied through the transmission medium 633 is received by the communicating section 103, and is stored in the program memories 2a, 2b. The transmission medium 633 may be a wired transmission medium or a wireless transmission medium.

### (Ordinary process of apparatus controlling device)

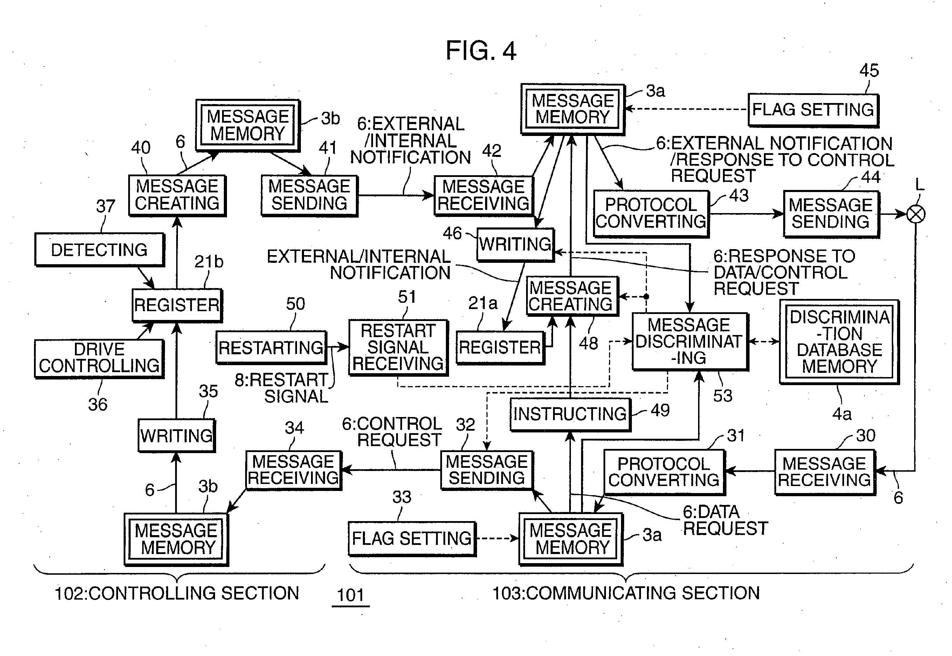

FIG. 4 is a block diagram depicted based on a function of the apparatus controlling device 101. The CPU 1a and the program memory 2a constitute the communicating section 103 shown in the example of FIG. 4 by cooperation with the message memory 3a and the discrimination database memory 4a. Likewise, a CPU 1b and a program memory 2b constitute the communicating section 102 shown in the example of FIG. 4 by cooperation with the message memory 3a. The communicating section 103 and the controlling section 102 shown in the example of FIG. 4 may be constructed by a hardware which requires no program.

A message receiving section 30 is for receiving the message (in this case, specifically called as "first message") 6 sent from the communications line L. After having been converted from a format based on protocol for the communications line L to a format based on protocol for communications in the apparatus controlling device 101 by a protocol converting section 31, the first message 6 received in the message receiving section 30 is stored in the message memory 3a. Normally, the first message 6 stored in the message memory 3a is read out therefrom upon lapse of a certain stand-by time. Part of the read-out first message 6 is sent to the controlling section 102 by a message sending section 32.

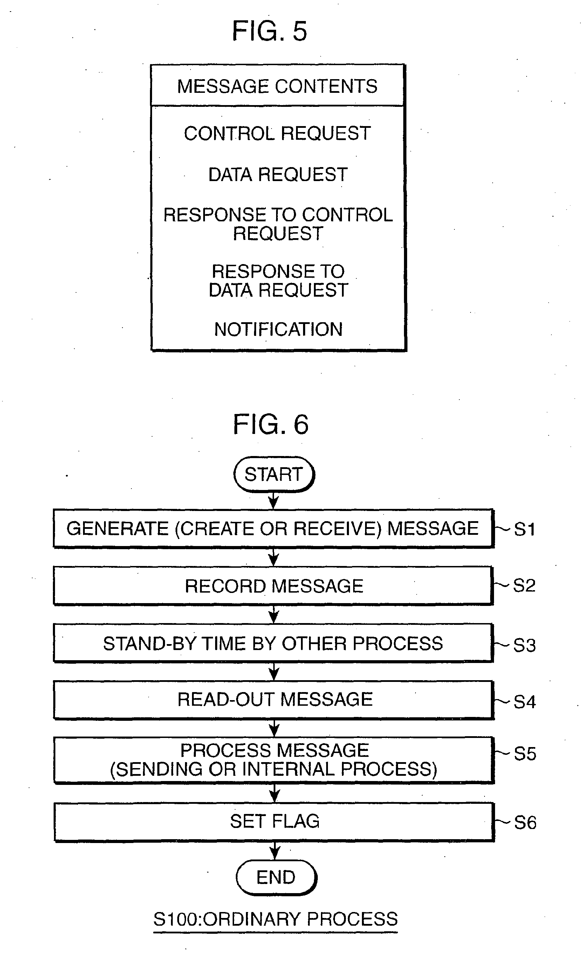

The contents of the message 6 to be handled by the apparatus controlling device 101 are classified into five kinds as shown in the example of FIG. 5. An example of control request is a request from the external device such as the controller 110: "Set the temperature to 4°C". An example of data request is a request from the external device such as the controller 110: "Send the temperature data". Upon receiving the control request, the communicating section 103 sends the control request to the controlling section 102, which in turn, implements the control as requested. Upon receiving the data request, the communicating section 103 sends the data as requested to the controller 110 or a like device.

An example of response to control request is a response indicating that the control request: "Set the temperature to 4°C" has been "received". The response is conducted by the communicating section 103 that has received the control request. An example of response to data request is sending the temperature data in response to a request: "Send the temperature data". As described above, the temperature data is sent by the communicating section 103 that has received the data request. An example of notification is such that the apparatus controlling device 101 voluntarily notifies the temperature data or the like, regardless of a status as to whether a request has been issued from the controller 110.

Referring back to FIG. 4, the first message 6 includes the control request and the data request. The control request in the first message 6 read out from the message memory 3a is sent to the controlling section 102 via the message sending section 32. The data request is processed in the communicating section 103, which will be described later. The first message 6 which is constituted of the control request and is sent from the message sending section 32 is received by the message receiving section 34 and stored in the message memory 3b. The first message 6 stored in the message memory 3b is read out by a writing section 35 and written in the register 21b.

The register 21b is for temporarily storing information regarding the statuses and set conditions of the components to be controlled, such as the condenser 105 and the temperature sensor 106, e.g., the internal temperature of the refrigerator 201, opened/closed state of the door, consumed power, and set temperature of the refrigerator 201. A drive controlling section 36 is for controlling driving of the components such as the condenser 105 to satisfy the set conditions stored in the register 21b. A detecting section 37 is, for example, for writing the data indicative of the internal temperature of the refrigerator 201 detected by the temperature sensor 106 in the register 21b. In this way, the external device such as the controller 110 enables to control the condenser 105, so that the internal temperature of the refrigerator 201 attains a newly set temperature by updating the temperature data stored in the register 21b by way of the message 6, and to know the internal temperature of the refrigerator 201 by way of the message 6 by reading out the temperature data stored in the register 21b.

Referring back to FIG. 4 again, a message creating section 40 is for reading out the data stored in the register 21b, and creating the message 6 based on the read-out data. The message 6 includes contents regarding a notification. The created message 6 is stored in the message memory 3b, and is normally read out upon lapse of a certain stand-by time, and sent to the communicating section 103 by a message sending section 41. The message (in this case, specifically called as "second message") 6 sent by the message sending section 41 is received by a message receiving section 42, and stored in the message memory 3a. The second message 6 stored in the message memory 3a is normally read out upon lapse of a certain stand-by time.

The notification in the second message 6 includes an external notification of notifying the message to the external device such as the controller 110 via the communications line L, and an internal notification of notifying the message to the communicating section 103. The internal notification in the second message 6 is read out from the message memory 3a by a writing section 46, and written in the register 21a. In this way, the contents stored in the register 21b are conveyed to the register 21a by way of the internal notification in the second message 6. The internal notification may be conducted when the contents in the register 21b are altered, or periodically. Similarly to the internal notification, the external notification in the second message 6 is read out from the message memory 3a by the writing section 46, and written in the register 21a.

When the data request in the first message 6 sent through the communications line L is read out from the message memory 3a, a message creating section 48 creates the message 6 based on an instruction issued from an instructing section 49. The message creating section 48 reads out the data stored in the register 21a, and creates a message (in this case, specifically called as "third message") 6 constituted of a response to the data request based on the read-out data. The third message 6 is stored in the message memory 3a.

The first message 6 constituted of the control request sent through the communications line L is read out from the message memory 3a, and sent to the controlling section 102, as described above. Simultaneously, the message creating section 48 creates a message 6 constituted of a response to the control request based on an instruction issued from the instructing section 49. The response to the control request is stored in the message memory 3a, as the third message 6.

The external notification in the second message 6, and the third message 6 constituted of the response to the control request and the response to the data request are read out from the message memory 3a, and converted from the format based on protocol for the internal communication to the format based on protocol for the communications line L by the protocol converting section 43. The message 6 after the protocol-conversion by the protocol converting section 43 is sent to the communications line L by a message sending section 44. The apparatus controlling device 101 primarily implements the following processes as the ordinary process.

FIG. 6 is a flowchart showing a primary control flow of the ordinary process in the communicating section 103 of the apparatus controlling device 101. When the ordinary process (Step S100) is initiated, the message 6 is received or created (Step S1) This process is implemented by the message receiving sections 30, 42, and the message creating section 48. After Step S1, the received or created message 6 is recorded in the message memory 3a (Step S2). Thereafter, upon lapse of a stand-by time in which the other process is implemented in the ordinary process (Step S3), the message 6 is read out from the message memory 3a (Step S4). Then, implemented are processes such as transmission to the controlling section 102, transmission to the communications line L, and an internal process (in this example, instruction to the message creating section 48 to create a message, and writing the message into the register 21a) with respect to each of the read-out messages 6 (Step S5).

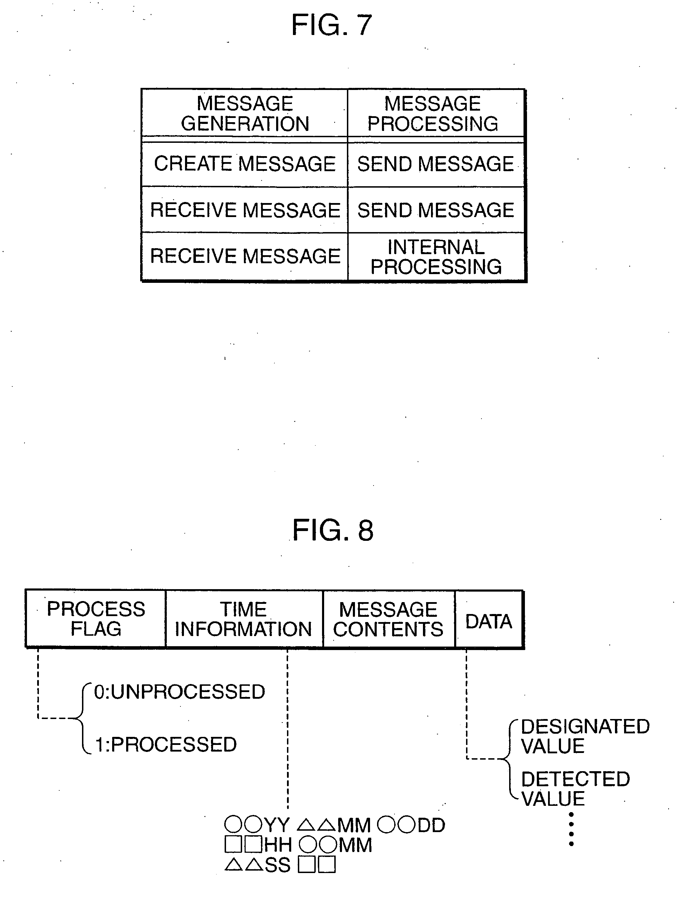

FIG. 7 is an illustration showing a relation between the message 6 generated in the communicating section 103, and a manner of processing the message 6. As shown in FIG. 7, the created message 6 is sent to the communications line L. The message 6 received through the communications line L is used for the transmission to the controlling section 102 or for the internal process (in this example, instruction to the message creating section 48 to create a message). The message 6 sent from the controlling section 102 is used for the transmission to the communications line L or for the internal process (in this example, writing into the register 21a).

Referring back to FIG. 6, upon completion of the process of Step S5, flag setting sections (ID code attaching sections) 33 and 45 (see FIG. 4) record the message 6 in the message memory 3a with an ID code representing that the message 6 has been processed being attached thereto. As will be described later, the ID code is utilized in processing a message that has been left unprocessed, after restart of the communicating section 103. The ordinary process (Step S100) cyclically repeats the above steps.

FIG. 8 is an illustration showing an example of a data structure of the message 6 to be stored in the message memory 3a. In this example, the message 6 includes a process flag, time information, message contents, and data. The process flag is set to "0", for example, in the case where the message 6 is stored in the message memory 3a. The process flag is set to "1" by the flag setting sections 33 and 45 when the process of Step S5 is completed. In this example, the numeral "0" denotes that the message 6 is unprocessed, whereas the numeral "1" denotes that the message 6 has been processed. The time information is stamped when the message 6 has been created or received, or when the message 6 has been recorded in the message memory 3a. The contents in the message 6 have already been described with reference to FIG. 5. Attachment or non-attachment of the data is determined depending on the contents of the message 6. The data includes a designated value of the set temperature, and a detected value of the internal temperature of the refrigerator 201.

### (Process of remaining message after restart)

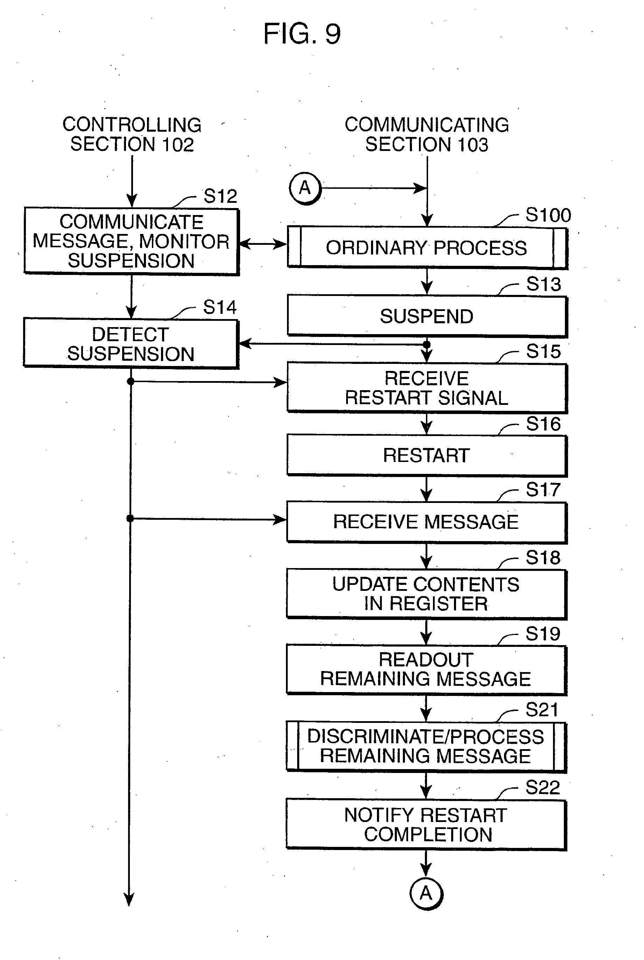

Now, a procedure as to how a remaining message is processed after restart of the communicating section 103 is described referring to the block diagram in FIG. 4 and the flowchart in FIG. 9. The database has been recorded in the discrimination database memory 4a before the CPU 1a of the communicating section 103 starts the ordinary process (Step S100). Normally, recording of the database is executed prior to shipment of the products. While the CPU 1a implements the ordinary process (Step S100), the controlling section 102 communicates the message 6 with the CPU 1a, and monitors a status as to whether the operation of the CPU 1a is suspended (Step S12). Further, as the CPU 1a implements the ordinary process (Step S100), the message 6 is recorded in the message memory 3a, and a flag is set accordingly (see FIG. 6).

Next, when the operation of the CPU 1a is suspended due to a cause such as an erroneous operation of the hardware (Step S13), a restarting section 50 of the controlling section 102 detects a suspension of the operation of the CPU 1a (Step S14), and sends a restart signal 8 to a restart signal receiving section 51 of the communicating section 103. When the restart signal receiving section 15 receives the restart signal 8 (Step S15), the operation of the CPU 1a is restarted (Step S16). Subsequently, the controlling section 102 conveys the contents in the register 21b to the communicating section 103 by sending the message 6 constituted of the internal notification to the communicating section 103. When the message receiving section 42 of the communicating section 103 receives the message 6 (Step S17), the contents in the register 21b are written in the register 21a via the message memory 3a and the writing section 46 (Step S18). In this way, the contents in the register 21a are updated to the latest contents stored in the register 21b. Next, a message discriminating section 53 reads out the message 6 stored in the message memory 3a (Step S19), and judges whether the message 6 is to be processed and implements a necessary process by referring to the database stored in the discrimination database memory 4a (Step S21).

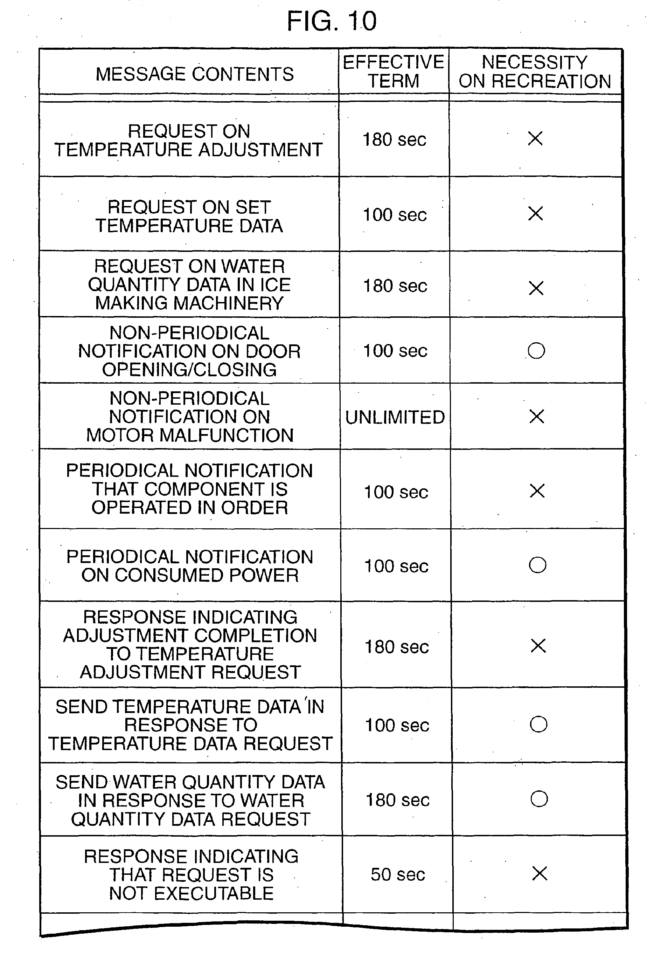

FIG. 10 is an illustration showing an example of the database to be stored in the discrimination database memory 4a. The database describes a term to be processed with respect to each of the contents of the message 6. The term to be processed is a term that is significant in implementing a process such as transmission of the message 6 after the message 6 has been received or created, namely, an effective term for the message 6. The effective term can be set at a relatively long period, e.g., 180 sec., with respect to a request regarding temperature adjustment. On the other hand, it is desirable to set the effective term at a relatively short period, e.g., 100 sec., with respect to a non-periodical notification such as a notification regarding opening/closing of the door of the refrigerator 201. The effective term with respect to a non-periodical notification such as malfunction of the motor of the refrigerator 201, such as alerting malfunction of the motor, lasts long, and accordingly is set at an unlimited term.

The database also describes necessity or non-necessity as to recreation of the message 6. ''To recreate" here means to create a message 6 with respect to the message 6 which has been left unprocessed in the message memory 3a and whose effective term has lapsed, based on the updated contents in the register 21a. For instance, a request on temperature adjustment is the message 6 received through the communications line L, and cannot be recreated in the communicating section 103. Accordingly, the database describes that recreation of the message 6 containing the request on temperature adjustment is not necessary. Since a periodical notification that the component is operated in order is expected to accompany a next periodical notification notifying the same condition, the database describes that recreation of the message 6 containing the periodical notification is not necessary. On the other hand, regarding a non-periodical notification as to opening/closing of the door of the refrigerator 201, it is desirable to notify a latest status as to opening/closing of the door, and accordingly, the database describes that recreation of the message 6 containing the notification is necessary.

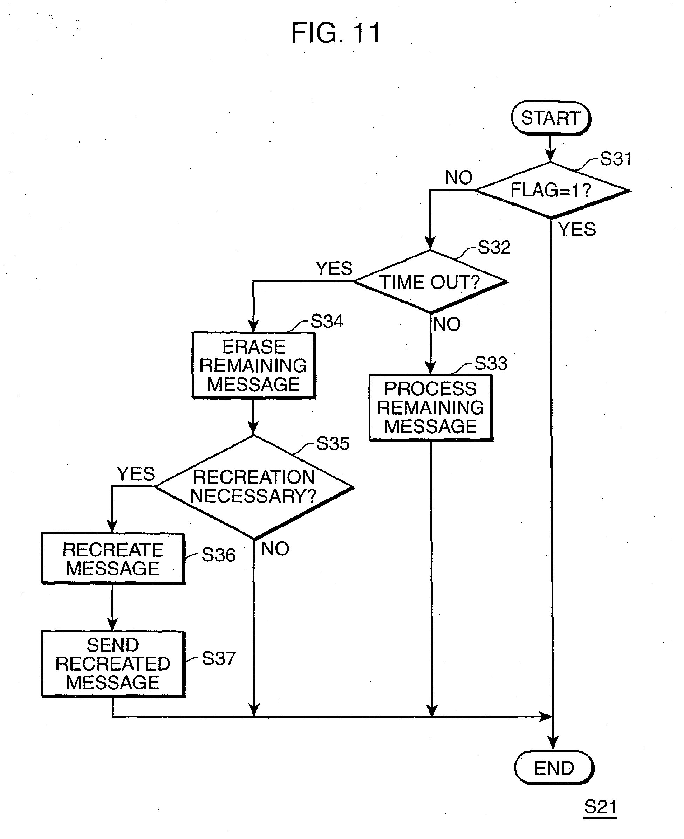

FIG. 11 is a flowchart showing a process flow of Step S21. The message discriminating section 53 implements the process of Step S21 with respect to each of the messages 6 read out from the message memory 3a. When the process of Step S21 is initiated with respect to a certain message 6, the message discriminating section 53 judges the state of the process flag attached to the message 6 (Step S31). If the process flag is set to "1" indicating that the message 6 has been processed (YES in Step S31), the process of Step S21 with respect to the message 6 is terminated. If the process flag is set to "0" indicating that the message 6 has not been processed (NO in Step S31), it is judged whether a difference in time between the current time and the time stamped on the message 6 is within the effective term described in the database (Step S32). If the time difference is within the effective term (NO in Step S32), the message 6 is sent by the message sending sections 32 and 44, and creation of a message is instructed by the instructing section 49 (Step S53). If the time difference exceeds the effective term (YES in Step S32), the remaining message 6 is erased from the message memory 3a by the message discriminating section 53 because the message 6 is not necessary (Step S34). Subsequently, the message discriminating section 53 judges whether recreation of the message 6 is necessary by referring to the database (Step S35). If recreation of the message 6 is not necessary (NO in Step S35), the process of Step S21 is terminated. If recreation of the message 6 is necessary (YES in Step S35), the message discriminating section 53 causes the message creating section 48 to create a message 6 (Step S36). The recreated message 6 is sent to the communications line L by the message sending section 44 via the protocol converting section 43 (Step S37). Thus, the process of Step S21 is terminated.

Referring back to FIG. 9, when the process of Step S21 is terminated, the message creating section 48 creates a message 6 constituted of a notification indicating that restart of the communicating section 103 is completed (Step S22). The restart completion notification is sent to the communications line L via the protocol converting section 43 and the message sending section 44. Thereafter, the communicating section 103 is resumed to the ordinary process (Step S100).

### (Advantage of First Embodiment)

As described above, the apparatus controlling device 101 in the first embodiment is configured in such a manner that the message 6 stored in the message memory 3a is read out in response to the restart signal 8 received in the communicating section 103 after the operation of the communicating section 103 is suspended, and the process such as transmission of the unprocessed message 6 whose effective term has not lapsed is conducted, based on the status of the process flag and by referring to the database stored in the discrimination database memory 4a. This arrangement makes it possible to process the message 6 that has been left unprocessed during suspension of the operation of the communicating section 103, and to save time required for implementing an unnecessary process with respect to the unprocessed message 6 whose effective term has lapsed. Further, in the first embodiment, the communicating section 103 having a function of protocol conversion and sharing a function or functions among a variety of kinds of apparatus controlling devices 101 is provided independently of the controlling section 102. This arrangement is advantageous in reducing the entire design cost regarding the variety of kinds of apparatus controlling devices 101 to be used in a variety of kinds of apparatuses such as the condenser 105.

Further, in the apparatus controlling device 101, in the case where the message 6 sent through the communications line L is constituted of a data request, the communicating section 103, in place of the controlling section 102, creates the message 6 serving as a response to the data request, and sends the message 6 to the controlling section 102, based on the contents in the register 21a that have been sent from the controlling section 102 and updated by the contents in the register 21b. This arrangement is advantageous in alleviating the relatively heavy burden of the controlling section 102 because the burden is shared by the communicating section 103, and in enhancing responsiveness to the data request.

Further, in the apparatus controlling device 101, the message creating section 48 newly creates a message 6 with respect to the message 6 that has been left unprocessed, whose effective term has lapsed by suspension of the operation of the communicating section 103 and that is to be recreated, by referring to the database. This arrangement enables to send the message 6 that reflects the new status after restart of the communicating section 103, in place of sending the message 6 whose effective term has lapsed, and to save time required for transmitting an unnecessary message.

In the apparatus controlling device 101, the message creating section 48 newly creates a message not only with respect to the message 6 created in the communicating section 103 but also with respect to the unprocessed message 6 constituted of a notification sent from the controlling section 102, and sends the newly created message to the communications line L by the message sending section 44, if it is judged that the unprocessed message 6 be recreated irrespective of a fact that the effective term has lapsed. This arrangement enables to send the new message 6 that reflects the new status after restart of the communicating section 103, in place of sending the unprocessed message 6 which has been sent from the controlling section 102 and whose effective term has lapsed, and to save time required for transmitting an unnecessary message.

In the apparatus controlling section 101, the controlling section 102 monitors the operation of the communicating section 103, and sends the restart signal 8 to the communicating section 103 if the operation of the communicating section 103 is suspended. Unlike in the case of the conventional art recited in D2 in which restart of the device is conducted manually by a user based on recognition of the user that the operation of the device is suspended, this arrangement is advantageous in shortening the operation suspended period of the device. Accordingly, the apparatus controlling device 101 is applicable to an apparatus such as a refrigerator, in which a long-term cooling suspended operation is prohibited, and to a security device, such as a sensor of detecting and alerting suspicious individuals, and a sensor of detecting and alerting a fire, in which even a short-term suspended operation is prohibited. Further, since the communicating section 102 monitors the operation of the communicating section 103, there is no need of additionally providing a device of monitoring the operation of the communicating section 103. Accordingly, the apparatus controlling device 101 can be produced with a low cost.

### [Second Embodiment]

### (Schematic construction of apparatus controlling device)

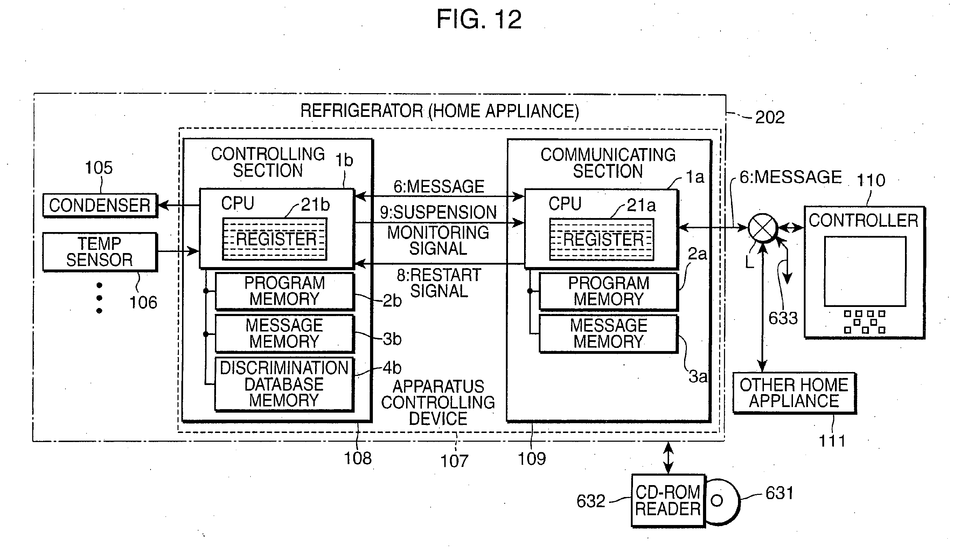

FIG. 12 is a block diagram showing a hardware configuration of an apparatus controlling device in accordance with a second embodiment of the present invention. Similarly to the first embodiment, in this embodiment, described is an example where the apparatus controlling device 107 is applied to a refrigerator 202.

The apparatus controlling device 107 includes a controlling section 108 and a communicating section 109. The apparatus controlling device 107 of the second embodiment is different from the apparatus controlling device 101 of the first embodiment in that: the controlling section 108 has a discrimination database memory 4b; a process of a remaining message during suspension of the operation of the controlling section 108 is implemented; and the communicating section 109 monitors the operation of the controlling section 108, and a restart signal 8 is sent from the communicating section 109 to the controlling section 108 if the operation of the controlling section 108 is suspended. In the apparatus controlling device 107, the controlling section 108 corresponds to an example of the message processor 100.

The discrimination database memory 4b stores a database describing judgment criteria as to whether an unprocessed message 6 remaining in a message memory 3b be processed when the operation of a CPU 1b is restarted, in response to the restart signal 8 sent from the controlling section 109 when the operation of the CPU 1b is suspended. Similarly to the message memory 3b, the discrimination database memory 4b is allocated with an address in which the stored contents are un-erasable in association with restart of the CPU 1b.

A CPU 1a has a function of restarting the operation of the CPU 1b when the operation of the CPU 1b is suspended. For instance, the CPU 1a receives a suspension monitoring signal 9 that is sent from the CPU 1b periodically, e.g. every 100 ms. If the CPU 1a fails to receive the suspension monitoring signal 9 for a certain duration, e.g. 1 second, the CPU 1a judges that the operation of the CPU 1b is suspended, and sends the restart signal 8 to the CPU 1b. Thereupon, the operation of the controlling section 108 is automatically resumed after temporarily suspending its operation.

### (Ordinary process of apparatus controlling device)

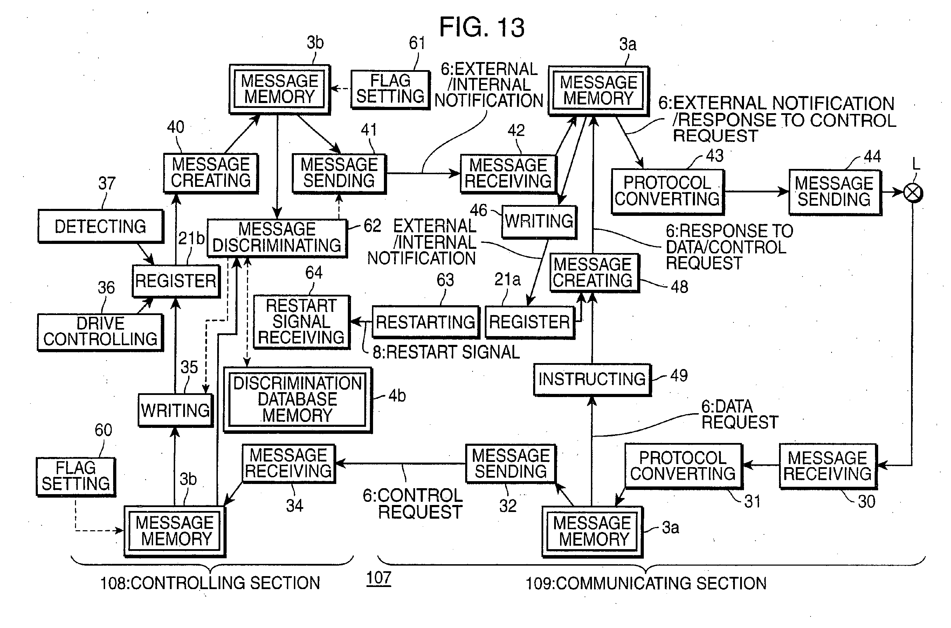

FIG. 13 is a block diagram depicted based on a function of the apparatus controlling device 107. Components in FIG. 13 equivalent to those in FIG. 4 are denoted at the same reference numerals, and detailed description thereof will be omitted herein. The CPU 1a and the program memory 2a constitute the communicating section 109 shown in the example of FIG. 13 by cooperation with a message memory 3a. Likewise, the CPU 1b and the program memory 2b constitute the controlling section 108 shown in the example of FIG. 13 by cooperation with the message memory 3a and the discrimination database 4b. The communicating section 109 and the controlling section 108 shown in the example of FIG. 13 may be constructed by a hardware which requires no program.

The apparatus controlling device 107 is different from the apparatus controlling device 101 shown in FIG. 4 in that flag setting sections 60, 61, a message discriminating section 62, and a restart receiving section 64 are provided in the controlling section 108, and a restarting section 63 is provided in the communicating section 109. The apparatus controlling device 107 is equivalent to the apparatus controlling device 101 except that a flag setting is implemented with respect to the message 6 stored in the message memory 3b in the ordinary process of the second embodiment. The ordinary process of the controlling section 108 is as shown in the example of FIG. 6.

### (Process of remaining message after restart)

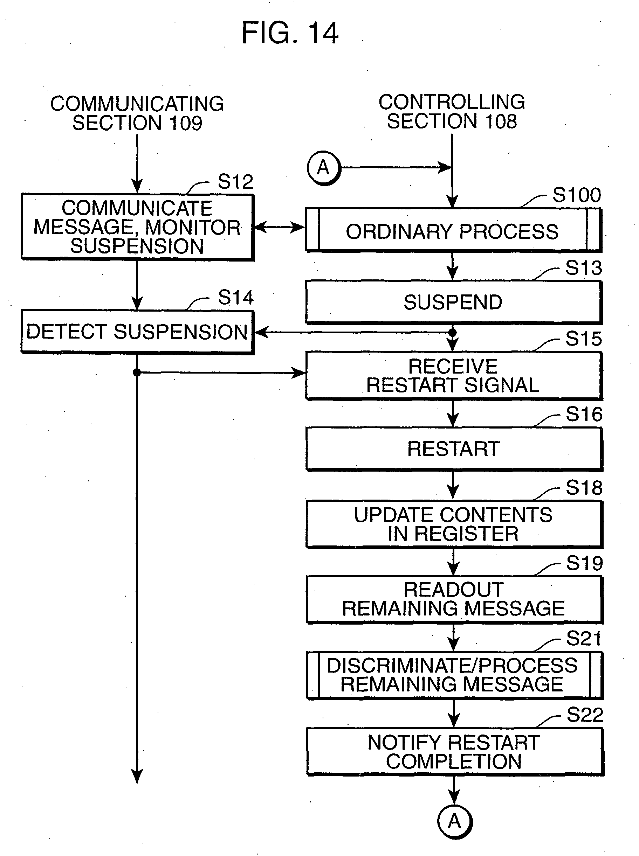

Now, described is a procedure as to how a remaining message is processed after restart of the controlling section 108, referring to the block diagram shown in FIG. 13 and the flowchart shown in FIG. 14. The steps in FIG. 14 corresponding to those in FIG. 9 are denoted at the same step numbers. The database has been recorded in the discrimination database memory 4b before the CPU 1b of the controlling section 108 starts the ordinary process (Step S100). While the CPU 1b implements the ordinary process (Step S100), the communicating section 109 communicates the message 6 with the CPU 1b, and monitors a status as to whether the operation of the CPU 1b is suspended (Step S12). Further, while the CPU 1b implements the ordinary process (Step S100), the message 6 is recorded in the message memory 3b, and a flag is set accordingly (see FIG. 6).

Next, when the operation of the CPU 1b is suspended due to a cause such as an erroneous operation of the hardware (Step S13), the restarting section 63 of the communicating section 109 detects a suspension of the operation of the CPU 1b (Step S14), and sends the restart signal 8 to the controlling section 108. When the restart signal receiving section 64 in the controlling section 108 receives the restart signal 8 (Step S15), the operation of the CPU 1b is restarted (Step S16). Subsequently, the CPU 1b updates the contents in a register 21b to latest contents in a register 21a (Step S18). Next, the message discriminating section 62 reads out the message 6 stored in the message memory 3b (Step S19), and judges whether the message 6 is to be processed, and implements a necessary process by referring to the database stored in the discrimination database memory 4b (Step S21).

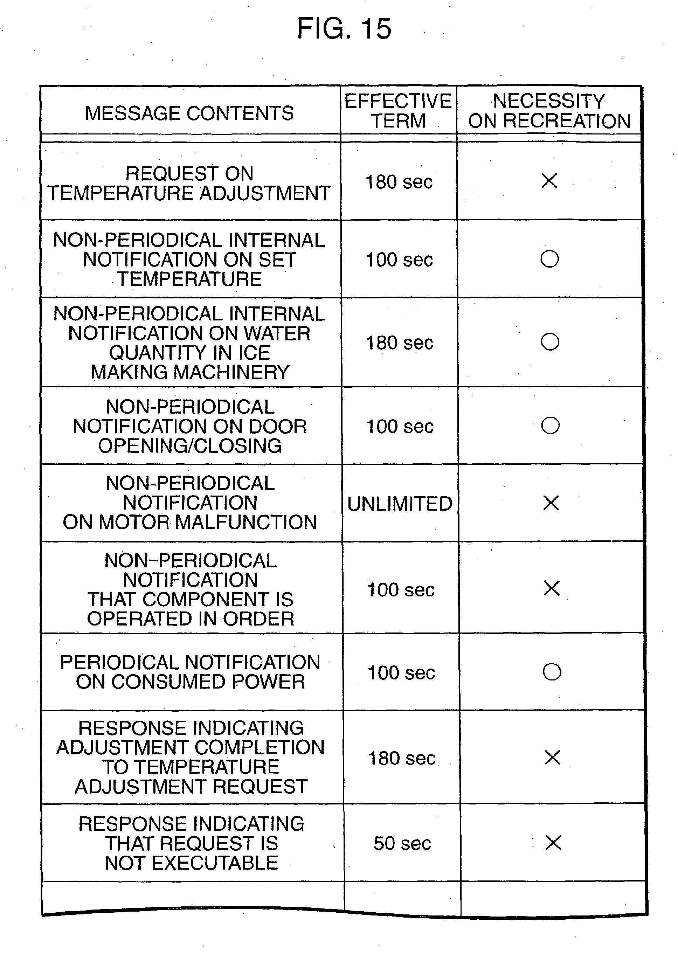

FIG. 15 is an illustration showing an example of the database stored in the discrimination database memory 4b. Similarly to the database (see FIG. 10) stored in the discrimination database memory 4a, the database describes the effective term and necessity/non-necessity of recreating the message 6 with respect to each of the contents of the message 6. ''To recreate" here means to create a message 6 with respect to the message 6 which has been left unprocessed in the message memory 3b and whose effective term has lapsed, based on the updated contents in the register 21b. Unlike in the case of the database shown in FIG. 10, as shown in FIG. 15, there is no need of describing necessity/non-necessity of recreating the message 6, as far as communication of the message 6 in the controlling section 108 is not required, such as a data request of requesting set temperature data, and a response to the data request indicating a response to the request on set temperature data.

Referring back to FIG. 14, the process flow of Step S21 is represented by the flowchart shown in the example of FIG. 11. The message discriminating section 62 implements the process of Step S21 with respect to each of the messages 6 read out from the message memory 3b. When the process of Step S21 is initiated with respect to a certain message 6, the message discriminating section 62 judges the state of the process flag attached to the message 6 (Step S31). If the process flag indicates that the message 6 has been processed (YES in Step S31), the process of Step S21 with respect to the message 6 is terminated. If the process flag indicates that the message 6 has not been processed (NO in Step S31), it is judged whether a difference in time between the current time and the time stamped on the message 6 is within the effective term described in the database (Step S32). If the time difference is within the effective term (NO in Step S32), transmission of the message 6 by the message sending section 41, and writing of the message 6 into the register 21b by a writing section 35 are implemented (Step S53). If the time difference exceeds the effective term (YES in Step S32), the remaining message 6 is erased from the message memory 3b by the message discriminating section 62 because the message 6 is not necessary (Step S34). Subsequently, the message discriminating section 62 judges whether recreation of the message 6 is necessary by referring to the database (Step S35). If recreation of the message 6 is not necessary (NO in Step S35), the process of Step S21 is terminated. If recreation of the message 6 is necessary (YES in Step S35), the message discriminating section 62 causes a message creating section 40 to create a message 6 (Step S36). The recreated message 6 is sent to the communicating section 109 via the message sending section 41 (Step S37). Thus, the process of Step S21 is terminated.

Referring back to FIG. 14, when the process of Step S21 is terminated, the message creating section 40 creates a message 6 constituted of a notification indicating that restart of the controlling section 108 is completed (Step S22). The restart completion notification is sent to the communications line L via the message sending section 41 and the communicating section 109. Thereupon, the controlling section 108 is resumed to the ordinary process (Step S100).

### (Advantage of Second Embodiment)

As described above, the apparatus controlling device 107 of the second embodiment is configured in such a manner that the message 6 stored in the message memory 3b is read out in response to the restart signal 8 received in the controlling section 108 after the operation of the controlling section 108 is suspended, and the process such as transmission of the unprocessed message 6 whose effective term has not lapsed is conducted, based on the status of the process flag and by referring to the database stored in the discrimination database memory 4b. This arrangement makes it possible to process the message 6 that has been left unprocessed during suspension of the operation of the controlling section 108, and to save time required for implementing unnecessary process with respect to the message 6 that has been left unprocessed and whose effective term has lapsed. Further, in the second embodiment, the communicating section 109 having a function of protocol conversion and sharing a function or functions among a variety of kinds of apparatus controlling devices 107 is provided independently of the controlling section 108. This arrangement is advantageous in reducing the entire design cost regarding the variety of kinds of apparatus controlling devices 107 to be used in a variety of kinds of apparatuses such as a condenser 105.

Further, in the apparatus controlling device 107, the message creating section 40 newly creates a message with respect to the message 6 that has been left unprocessed, whose effective term has lapsed by suspension of the operation of the controlling section 108 and that is to be recreated, by referring to the database. This arrangement enables to send the newly created message 6 that reflects the new status after restart of the controlling section 108, in place of sending the message 6 whose effective term has lapsed, and to save time required for transmitting an unnecessary message.

In the apparatus controlling section 107, the communicating section 109 monitors the operation of the controlling section 108, and sends the restart signal 8 to the controlling section 108 if the operation of the controlling section 108 is suspended. Unlike in the case of the conventional art recited in D2 in which restart of the device is conducted manually by a user based on recognition of the user that the operation of the device is suspended, this arrangement is advantageous in shortening the operation suspended period of the device. Accordingly, the apparatus controlling device 107 is applicable to an apparatus such as a refrigerator, in which a long-term cooling suspended operation is prohibited, and to a security device, such as a sensor of detecting and alerting suspicious individuals, and a sensor of detecting and alerting a fire, in which even a short-term suspended operation is prohibited. Further, since the communicating section 109 monitors the operation of the controlling section 108, there is no need of additionally providing a device of monitoring the operation of the controlling section 108. Accordingly, the apparatus controlling device 107 can be produced with a low cost.

### [Third Embodiment]

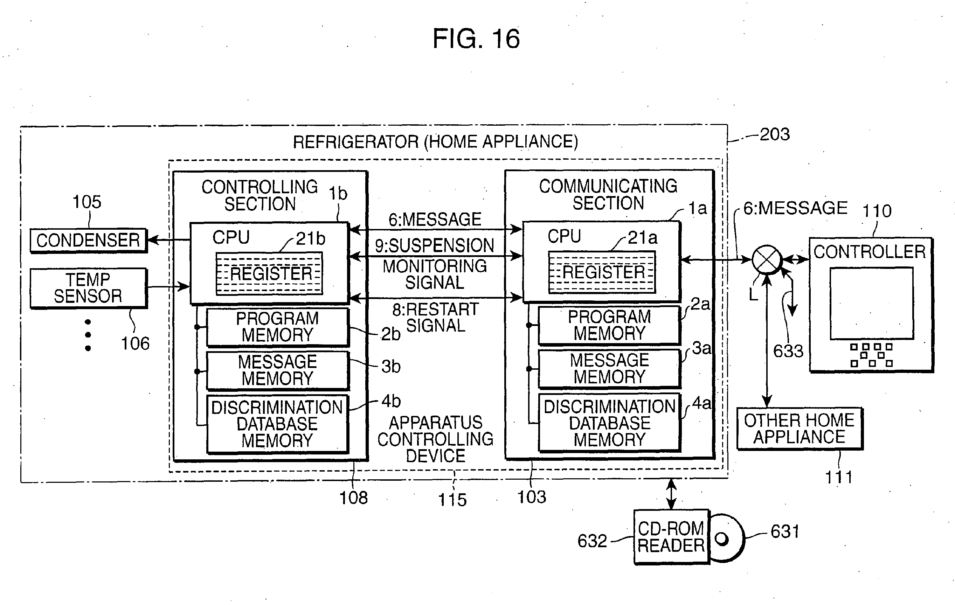

FIG. 16 is a block diagram showing a hardware configuration of an apparatus controlling device in accordance with a third embodiment of the present invention. The apparatus controlling device 115 is provided with the communicating section 103 in accordance with the first embodiment and the controlling section 108 in accordance with the second embodiment. In this arrangement, the communicating section 103 (or the controlling section 108) implements processing of a remaining message after restart of the controlling section 108 (or the communicating section 103). Further, the communicating section 103 and the controlling section 108 mutually monitor the operation of the counterpart component, and send a restart signal 8 to the counterpart component upon detecting that the operation of the counterpart component is suspended. In this arrangement, the apparatus controlling device 115 realizes both of the advantages of the apparatus controlling device 101 in accordance with the first embodiment and the apparatus controlling device 107 in accordance with the second embodiment.

### [Modification of First to Third Embodiments]

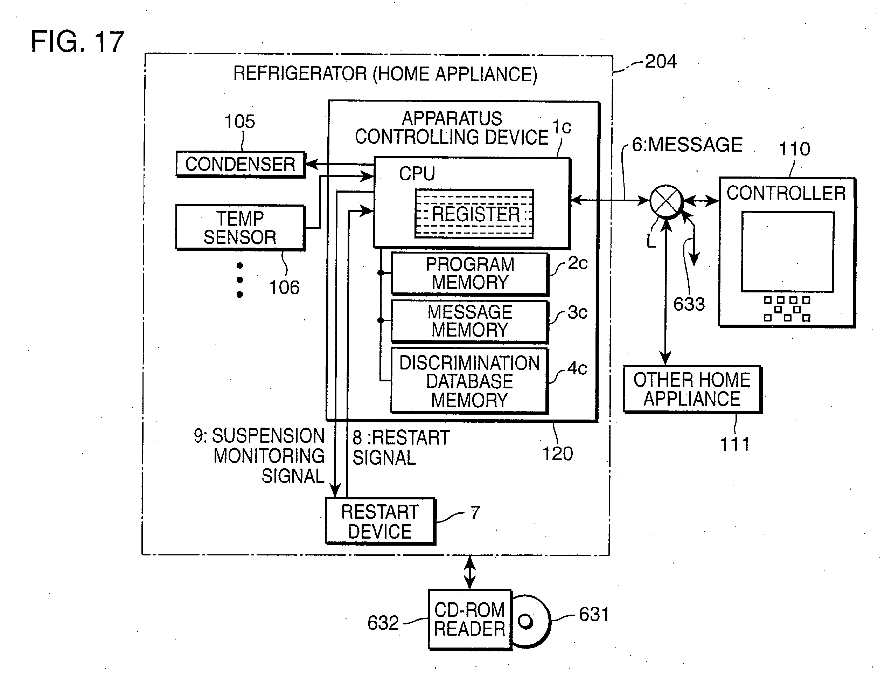

As shown in the block diagram of FIG. 17, it is possible to configure an apparatus controlling device 120, in which a controlling section and a communicating section are constructed into a one-piece unit, and a single CPU 1c, program memory 2c, message memory 3c, and discrimination database memory 4c are shared by the controlling section and the communicating section. A restart device 7 is electrically connected with the apparatus controlling device 120 to restart the apparatus controlling device 120.

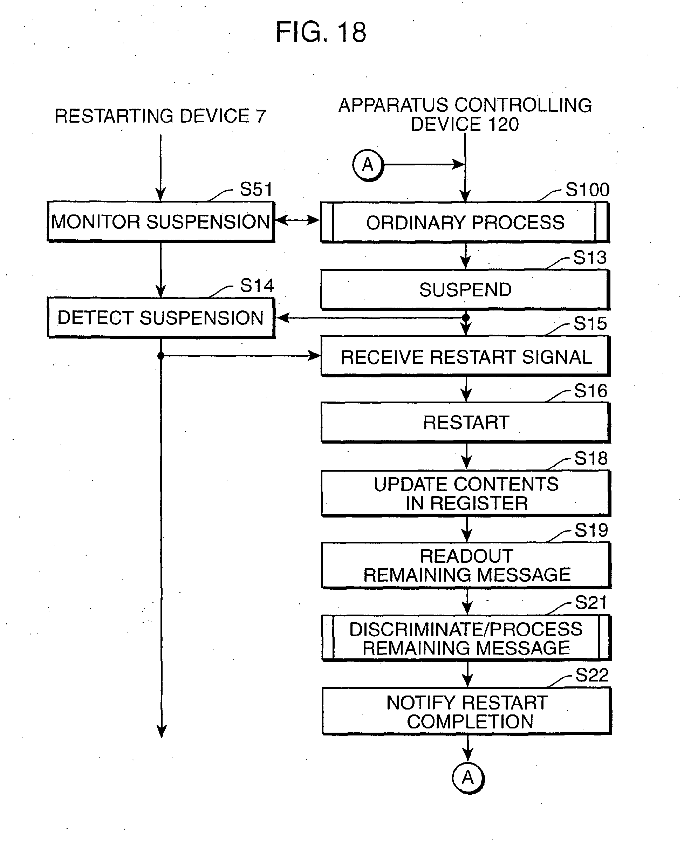

An operation procedure of the apparatus controlling device 120 is exemplified by the flowchart in FIG. 18. Since there is no need of communicating the message 6 between the controlling section and the communicating section in the apparatus controlling device 120, the operation procedure of the apparatus controlling device 120 is analogous to that of the controlling section 108 shown in the example of FIG. 14. Specifically, the operation procedure of the apparatus controlling device 120 is equivalent to that in FIG. 14 except that in the ordinary process (Step S100) of this modification, there is no recipient or sender of the message 6 other than the communications line L, and the restart device 7 monitors suspension of the operation of the apparatus controlling device 120 (Step S51). The process of Step S21 is implemented in accordance with the flowchart shown in FIG. 11.

Similarly to the foregoing embodiments, in the apparatus controlling device 120 having the above configuration, the message 6 stored in the message memory 3c is read out in response to a restart signal 8 received in the apparatus controlling device 120 after the operation of the apparatus controlling device 120 is suspended, and a process such as transmission of the unprocessed message 6 whose effective term has not lapsed is conducted, based on the status of the process flag and by referring to the database stored in the discrimination database memory 4c. This arrangement makes it possible to process the message 6 that has been left unprocessed during suspension of the operation of the apparatus controlling device 120, and to save time required for implementing an unnecessary process with respect to the unprocessed message 6 whose effective term has lapsed.

Further, in the apparatus controlling device 120, a message 6 is newly created with respect to the message 6 that has been left unprocessed, whose effective term has lapsed by suspension of the operation of the apparatus controlling device 120 and that is to be recreated, by referring to the database. This arrangement enables to send the newly created message 6 that reflects the new status after restart of the apparatus controlling device 120, in place of sending the message 6 whose effective term has lapsed, and to save time required for transmitting an unnecessary message.

### [Fourth Embodiment]

### (Entire configuration)

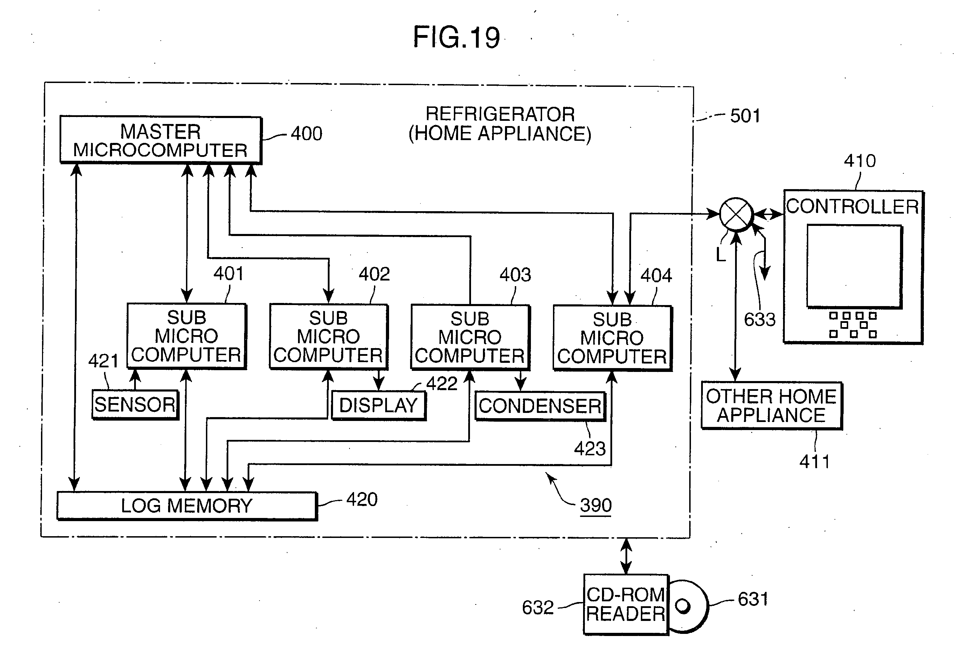

FIG. 19 is a block diagram showing a configuration of a microcomputer system in accordance with a fourth embodiment of the present invention. The microcomputer system 390 is applied to a refrigerator 501 as an example of home appliance, and includes a master microcomputer 400, sub microcomputers 401, 402, 403, 404, and a log memory 420.

The sub microcomputers 401, 402, 403, 404 individually play roles of controlling respective components of the refrigerator 501. In the example of FIG. 19, the sub microcomputer 401 controls a sensor 421 for measuring the internal temperature of the refrigerator 501. The sub microcomputer 402 controls a display device 422 such as a liquid crystal display panel for displaying the temperature and the like. The sub microcomputer 403 controls a condenser 423. The sub microcomputer 404 serves as a communicating section for relaying communication between a controller 410 and other home appliance 411, and the master microcomputer 400 and the other sub microcomputers 401, 402, 403, by being connected with a communications line L. The communicating section is a component which is provided between internal components of the microcomputer system and the communications line L and which primarily implements protocol conversion of a message to interface with the internal components of the microcomputer system and the communications line L. The communications line L is, for example, a facility network, based on ECHONET standards. A communication medium of the communications line L may be a wire or wireless. As an example of the wireless medium, a specific small-power wireless or Bluetooth® technology may be applicable. Communications within the microcomputer system 390 may not comply with ECHONET standards even if the communications line L be configured in compliance with ECHONET standards.

The master microcomputer 400 is a microcomputer of coordinating operations of the sub microcomputers 401, 402, 403, 404. Communication of the message among the sub microcomputers 401, 402, 403, 404 is implemented via the master microcomputer 400. It is possible for the master microcomputer 400 to directly communicate the message with the sub microcomputers 401, 402, 403, 404. The master microcomputer 400 has plural data input/output ports to which data input/output ports of the sub microcomputers 401, 402, 403, 404 are connected individually via a data line. This arrangement enables to communicate different messages between the master microcomputer 400, and the sub microcomputers 401, 402, 403, 404 simultaneously in parallel independently of each other. This arrangement makes it possible for each of the sub microcomputers 401, 402, 403, 404 to communicate the message with the master microcomputer 400 without waiting for an instruction, e.g., a trigger signal from the master microcomputer 400. The data input/output port may be a serial port or a parallel port. Thus, the microcomputer system 390 realizes organic control operation regarding the entirety of the refrigerator 501, and communication with an external device via the communications line L by exchanging the message among the sub microcomputers 401, 402, 403, 403, and the master microcomputer 400.

The log memory 420 is a memory for recording the communication log of the message, and the like. The log memory 420 is so configured that every one of the master microcomputer 400, and the sub microcomputers 401, 402, 403, 404 can read and write data therefrom and thereinto.

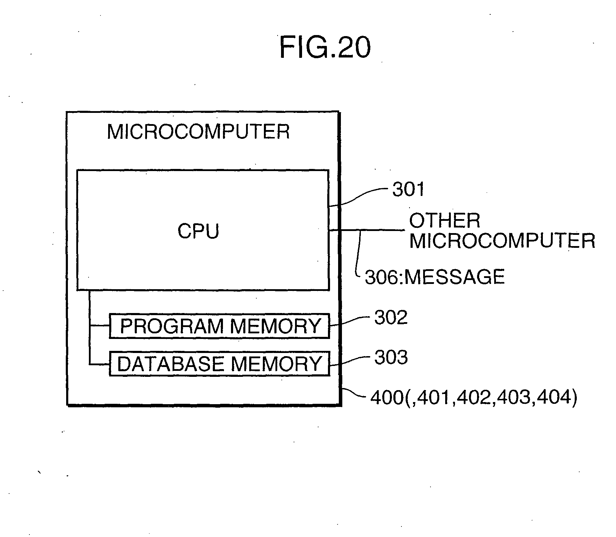

FIG. 20 is a block diagram showing a hardware configuration of each of the master microcomputer 400, and the sub microcomputers 401, 402, 403, 404. Each of the master microcomputer 400, and the sub microcomputers 401, 402, 403, 404 is provided with a CPU 301, a program memory 302, and a database memory 303. The CPU 301 controls various components such as the sensor 421, the display device 422, and the condenser 423, or communicates the message 306 with the other microcomputer(s) in accordance with a program stored in the program memory 302.

The database memory 303 stores a database providing judgment criteria as to whether an unprocessed message 306 remaining in the log memory 420 (see FIG. 19) is to be processed when the CPU 301 is restarted, in response to a restart signal sent from an external device when the operation of the CPU 301 is suspended due to an erroneous transmission of the message 306 sent through the communications line L, or an internal process of the microcomputer system 390. Both the database memory 303 and the log memory 420 are allocated with an address in which the stored contents are un-erasable in association with restart of the CPU 301. This arrangement enables to keep the message 306 stored in the database memory 303, and the message 306 stored in the log memory 420 from being erased in association with restart of the CPU 301.

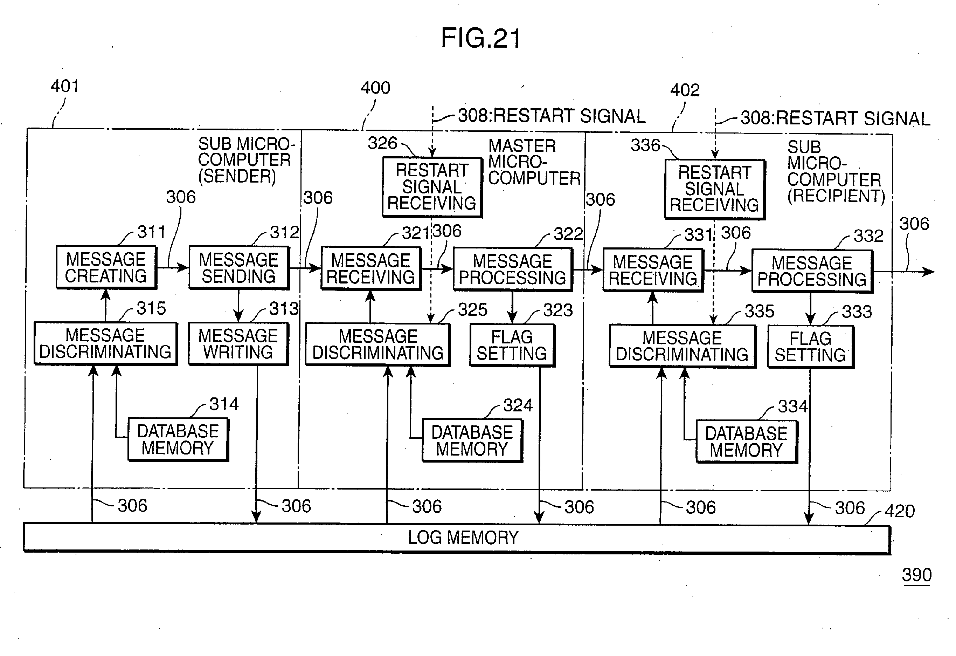

FIG. 21 is a block diagram depicted based on a function of the microcomputer system 390. The CPUs 301 and the program memories 302 of the respective microcomputers constitute the microcomputer system 390 shown in the example of FIG. 21 by cooperation with the database memories 303 and the log memories 420. The microcomputer system 390 shown in the example of FIG. 21 may be configured by a hardware which requires no program. In such an altered arrangement, FIG. 21 will be an illustration showing the hardware construction. In the example of FIG. 21, the sub microcomputer 401 sends the message to the master microcomputer 400, which in turn relays or processes the received message depending on the contents of the message, and the sub microcomputer 402 processes the received message. The functions of the respective sub microcomputers 401, 402, 403, 404 are not fixed regarding communication of the message, and the respective functions thereof may be varied depending on the contents of the message.

Referring back to FIG. 19, similarly to the description on FIG. 3, the program that defines the operations of the CPUs 301 of the sub microcomputers 401, 402, 403, 403 may be supplied through a recording medium 631 including an ROM, a flexible disc, and a CD-ROM, or may be supplied through a transmission medium 633 (including the communications line L) such as a telephone line and a network. FIG. 19 shows a CD-ROM as an example of the recording medium 631, and a telephone line as an example of the transmission medium 633. The communications line L may be a telephone line. The program recorded in the CD-ROM can be read out therefrom by connecting a CD-ROM reader 632 as an external device of the refrigerator 501 with an interface (not shown) or the like for storage in the program memory 302. In the case where a software and data are supplied in the form of an ROM as an example of the recording medium 631, the microcomputer system 390 can execute the process in accordance with the program by installing the ROM serving as the program memory 302 in each of the microcomputers 400, 401, 402, 403, 404. The program to be supplied through the transmission medium 633 is received by the sub microcomputer 404, and is stored in the program memory 302 of each of the microcomputers 400, 401, 402, 403, 404. The transmission medium 633 may be a wired transmission medium or a wireless transmission medium.

### (Ordinary process)

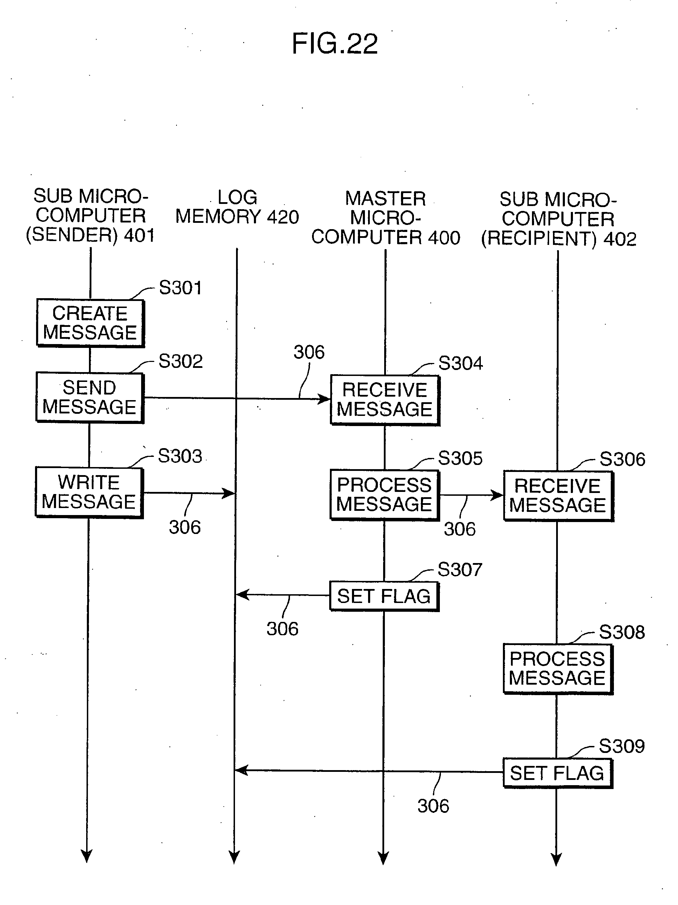

FIG. 22 is a flowchart showing a process flow of the ordinary operation of the master microcomputer 400, and the sub microcomputers 401, 402 shown in the example of FIG. 21. In the following, the ordinary operations of the master microcomputer 400 and the sub microcomputers 401, 402, are described referring to FIGS. 21 and 22.

When the ordinary operation is initiated, a message creating section 311 of the sub microcomputer 401 creates a message 306 (Step S301). The message creating section 311, for example, creates a message notifying the internal temperature of the refrigerator 501, based on the internal temperature detected by the sensor 421. The created message 306 is sent to the master microcomputer 400 by a message sending section 312 (Step S302). A message writing section 313 of the sub microcomputer 401 records the message 306 sent from the message sending section 312 in the log memory 420 (Step S303).

On the other hand, the master microcomputer 400 receives the message 306 by a message receiving section 321 (Step S304). A message processing section 322 processes the received message 306 depending on the contents of the message 306 (Step S305). For instance, if the message 306 is to be sent to the sub microcomputer 402, the message processing section 322 sends the message 306 to the sub microcomputer 402 as one of the processes regarding the message 306. Further, if the message 306 is to be sent to the master microcomputer 400, the message processing section 322 implements a process other than the message transmission depending on the contents of the message 306.

The CPU 301 of the master microcomputer 400 implements various processes. Accordingly, a stand-by time is generated in the ordinary process of the CPU 301 of the master microcomputer 400 until the process by the message processing section 322 is performed after the message receiving section 321 of the master microcomputer 400 receives the message 306. As a result, if the operation of the CPU 301 of the master microcomputer 400 is suspended, the message 306 is left unprocessed in the log memory 420 because the stand-by time has not lapsed. The operation of the master microcomputer 400 including a database memory 324 is suspended if the operation of the CPU 301 of the master microcomputer 400 is suspended.

Upon completion of the process by the message processing section 322, a flag setting section (ID code attaching section) 323 sets a flag indicating that the message 306 has been processed, and records the message 306 in the log memory 420 (Step S307).

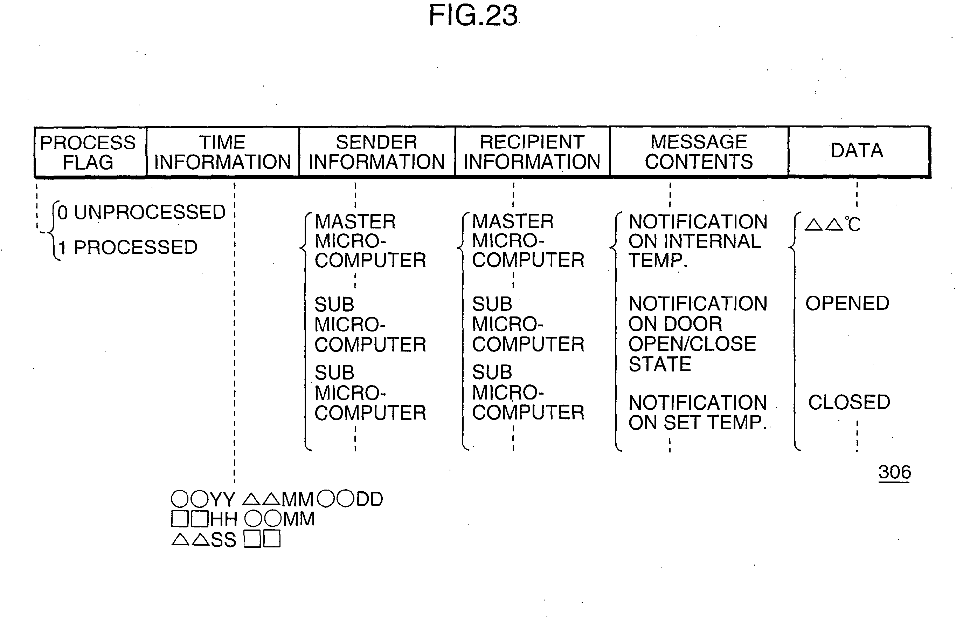

FIG. 23 is an illustration showing an example of a data structure of the message 306 to be recorded in the log memory 420. In this example, the message 306 includes a process flag, time information, information relating to a sender, information relating to a recipient, message contents, and data. The process flag is set to "0", for example, in the case where the message 306 is recorded in the log memory 420 by the message writing section 313. The process flag is set to "1" by the flag setting section 323 when the process by the master microcomputer 400 is terminated. In this example, the numeral "0" denotes that the message 306 is unprocessed, whereas the numeral "1" denotes that the message 306 has been processed. The time information is stamped when the message 306 has been created, or when the message 306 has been recorded in the log memory 420 by the message writing section 313.

The information relating to the sender is information of identifying the sender of the message 306 among the master microcomputer 400, and the sub microcomputers 401, 402, 403, 404. The information relating to the recipient is information of identifying the recipient of the message 306 among the master microcomputer 400, and the sub microcomputers 401, 402, 403, 404. The message contents include, for example, a notification regarding the internal temperature of the refrigerator 501 detected by the sensor 421, a notification regarding the opened/closed state of the door of the refrigerator 501 detected by a door sensor (not shown), and a notification regarding the set internal temperature of the refrigerator 501. Attachment or non-attachment of data is determined depending on the contents of the message 306. For instance, if the message 306 is constituted of the notification regarding the internal temperature of the refrigerator, data indicating the internal temperature (e.g., 2.1°C) is attached to the message 306. If the message 306 is constituted of the notification regarding the opened/closed state of the door, data indicating that the door is "opened" or "closed" is attached to the message 306.

Referring back to FIGS. 21 and 22, in the case where the message 306 is to be sent to the sub microcomputer 402, as mentioned above, the message processing section 322 of the master microcomputer 400 sends the message 306 to the sub microcomputer 402 (Step S305). When the process by the message processing section 322 is terminated, the flag setting section (ID code attaching section) 323 sets the process flag to "1" indicating that the message 306 has been processed, and records the message 306 in the log memory 420 (Step S307). Then, the sub microcomputer 402 receives the message 306 by the message receiving section 331 (Step S306), and a message processing section 332 processes the received message 306 depending on the message contents (Step S308).

Similarly to the operation of the CPU 301 of the master microcomputer 400, the CPU 301 of the sub microcomputer 402 implements various processes. Accordingly, a stand-by time is generated in the ordinary process of the CPU 301 of the sub microcomputer 402 until the process by the message processing section 332 is implemented after the message receiving section 331 of the sub microcomputer 402 receives the message 306. As a result, if the operation of the CPU 301 of the sub microcomputer 402 is suspended, the message 306 is left unprocessed in the log memory 420 because the stand-by time has not lapsed. The operation of the sub microcomputer 402 including a database memory 334 is suspended if the operation of the CPU 301 of the sub microcomputer 402 is suspended.

When the process by the message processing section 332 is terminated, the flag setting section (ID code attaching section) 333 sets the process flag indicating that the message 306 has been processed, and records the message 306 in the log memory 420 (Step S309). Specifically, in the examples of FIGS. 21 and 22, if the message 306 is to be sent to the sub microcomputer 402, used is a flag for judging whether the process by the sub microcomputer 402 as the recipient has been completed, other than the flag for judging whether the relay transmission of the message 306 by the master microcomputer 400 has been completed. In this way, the log on the process of the message 306 is recorded in the log memory 420.

The log on the message 306 stored in the log memory 420 is used in processing the remaining message after restart of the master microcomputer 400 or the sub microcomputer 402, which will be described later. This arrangement makes it possible to process the unprocessed message in the log memory 420 after restart of the master microcomputer 400 merely with use of a flag for judging whether the process by the message processing section 322 of the master microcomputer 400 has been completed. This arrangement also makes it possible to process the unprocessed message in the log memory 420 after restart of the sub microcomputer 402 merely with use of a flag for judging whether the process by the message processing section 332 of the sub microcomputer 402 has been completed.

### (Process of remaining message after restart of master microcomputer)

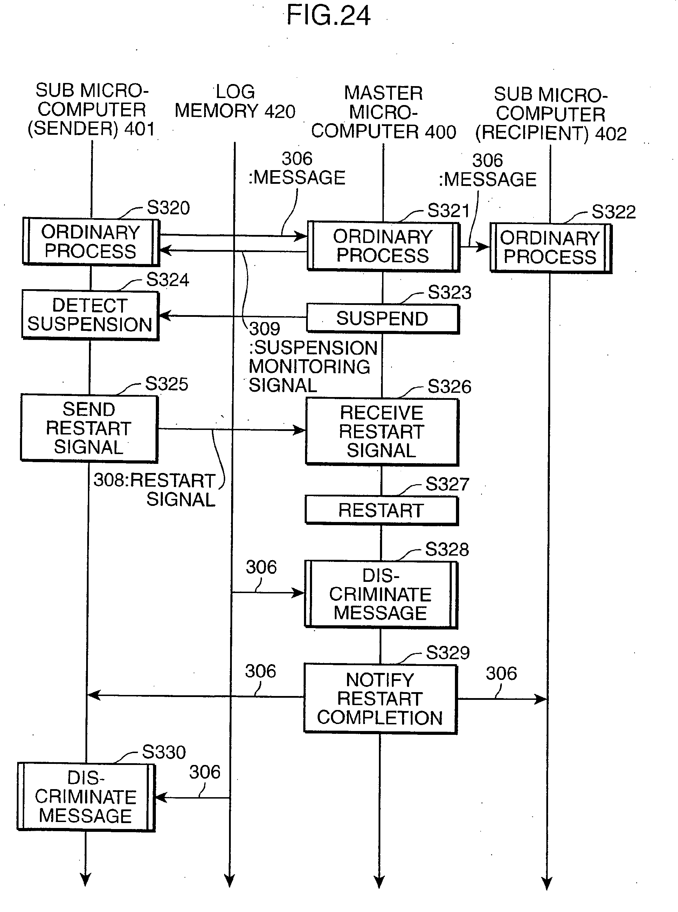

Now, a procedure as to how the unprocessed message is processed after restart of the master microcomputer 400 is described referring to the block diagram shown in FIG. 21 and the flowchart shown in FIG. 24. Before the sub microcomputer 401, the master microcomputer 400, and the sub microcomputer 402 initiate respective ordinary operations (Step S320, S321, and S322), databases have been recorded in the database memories 314, 324, and 334. Recording of the databases is normally executed before shipment of the goods. The contents of the databases will be described later.

The flow of ordinary processes of Steps S320, S321, and S322 is as shown in FIG. 22. While the master microcomputer 400, and the sub microcomputers 401 and 402 implement the ordinary processes (Steps S320, S321, and S322), communication by the message 306 is conducted, and the log on the message 306 is stored in the log memory 420. Further, while the ordinary processes are conducted, a state of the master microcomputer 400 is monitored as to whether the operation of the master microcomputer 400 is suspended. Monitoring of the suspension of the operation is executed by the sub microcomputer 401 in the example of FIG. 24. The sub microcomputer 401 receives a suspension monitoring signal 309 which is outputted, for example, periodically from the master microcomputer 400, and judges that the operation of the master microcomputer 400 is suspended if the sub microcomputer 401 fails to receive the suspension monitoring signal 309 for a certain period.

Next, when the operation of the master microcomputer 400 is suspended due to a cause such as an erroneous operation of the hardware (Step S323), the sub microcomputer 401 detects the suspension of the operation (Step S324), and sends the restart signal 308 to the master microcomputer 400 (Step S325). When the restart signal receiving section 326 of the master microcomputer 400 receives the restart signal 308 (Step S326), the master microcomputer 400 is restarted (Step S327). Subsequently, a message discriminating section 325 judges whether the message 306 (including an unprocessed message) recorded in the log memory 420 is to be processed, and implements a necessary process (Step S328). The process of Step S328 is implemented by referring to the database stored in the database memory 324 of the master microcomputer 400.

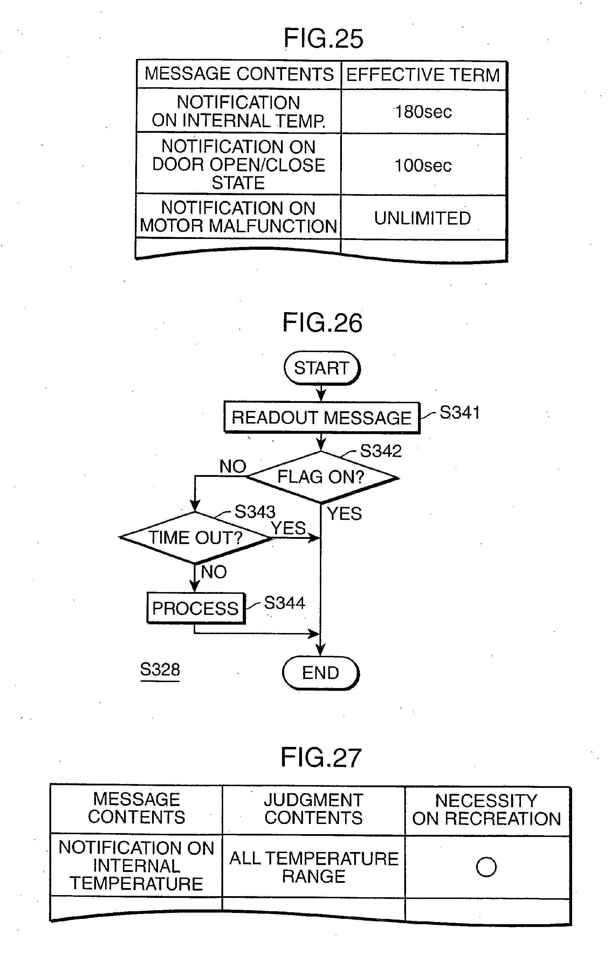

FIG. 25 is an illustration showing an example of the database to be stored in the database memory 324. The database describes a term to be processed with respect to each of the contents of the message 306. The term to be processed is a term that is significant in implementing a process after the message 306 is created or sent, namely, an effective term for the message 306. The effective term can be set at a relatively long period, e.g., 180 sec., with respect to a notification on the internal temperature of the refrigerator 501. On the other hand, it is desirable to set the effective term at a relatively short period, e.g., 100 sec., with respect to a non-periodical notification such as a notification regarding opening/closing of the door of the refrigerator 501. The effective term with respect to a non-periodical notification such as malfunction of the motor of the refrigerator 501, such as alerting malfunction of the motor, lasts long, and accordingly is set at an unlimited term.

FIG. 26 is a flowchart showing a process flow of Step S328. The message discriminating section 325 reads out the message 306 from the log memory 420 when the process of Step S328 is initiated (Step S341). Then, the message discriminating section 325 judges the state of the process flag attached to the message 306 (Step S342). If the process flag indicates that the process by the message processing section 322 is completed (YES in Step S342), the process of Step S328 with respect to the message 306 is terminated. If, on the other hand, the process flag indicates that the process by the message processing section 322 is not completed (NO in Step S342), it is judged whether the difference in time between the current time and the time stamped on the message 306 is within the effective term described in the database (Step S343). If the time difference is within the effective term (No in Step S343), the message discriminating section 325 causes the message processing section 322 to implement the process with respect to the message 306 (Step S344). The message discriminating section 325 may individually execute the processes of Steps S341 through S344 with respect to each of the messages 306 recorded in the log memory 420, or may integrally execute the readout process of Step 5341, and execute the processes of Steps S342 through S344 with respect to each of the read-out messages 306 after the integral read-out process.

Referring back to FIGS. 21 and 24, when the process of Step S328 is completed, the master microcomputer 400 sends the message 306 constituted of a notification notifying restart completion to the other microcomputers, namely, to the sub microcomputers 401 and 402 by the message processing section 322 (Step S329). The other microcomputers can be notified that the restart of the master microcomputer 400 has been completed by receiving the notification. The sub microcomputer 401 judges whether the message 306 recorded in the log memory 420 is to be processed by the message discriminating section 315, and implements a necessary process when, for example, a message receiving section (not shown) receives the restart completion notification from the master microcomputer 400 (Step S330). The process of Step S330 is implemented by referring to the database memory 314 of the sub microcomputer 401.

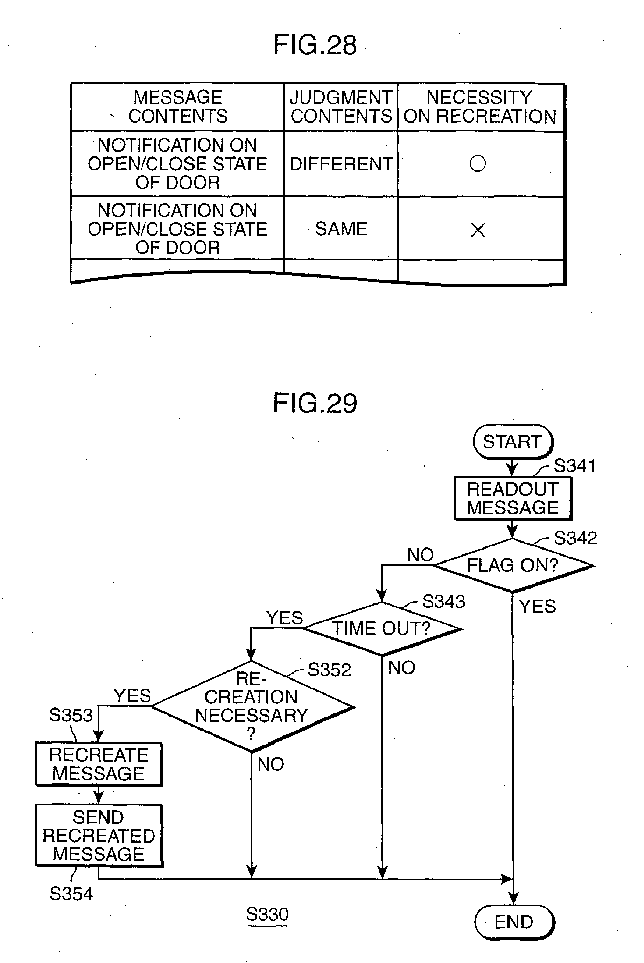

The effective term is described in the database stored in the database memory 314, as shown in the example of FIG. 25, with respect to each of the contents of the message 306. Necessity or non-necessity on recreating the message 306 is described in the database, as shown in the example of FIG. 27 or 28. Throughout the present specification and claims, "to recreate" means to newly create a message 306 with respect to the message 306 which has been recorded unprocessed in the log memory 420 and whose effective term has lapsed, based on the information that reflects the new status after restart of the microcomputer. For instance, necessity on recreation regarding all the temperature range is described if the message is constituted of a notification notifying the internal temperature of the refrigerator 501 (FIG. 27). Necessity on recreation so as to notify the new status regarding the opened/closed state of the door of the refrigerator 501 is described in the case where the contents of the message 306 that has been left unprocessed in the log memory 420, and the new status after restart of the microcomputer are not identical to each other. On the other hand, non-necessity on recreation is described in the case where the former and the latter are substantially identical to each other (see FIG. 28).

The sub microcomputers 401, 402, 403, 404 individually play roles of controlling respective components of the refrigerator 501. Accordingly, the contents of the message 306 to be handled are not identical to each other among these sub microcomputers. In view of this, the contents of the databases to be stored in the database memories 314, 334, or the like (see FIG. 21) may be different from each other between the sub microcomputers, as shown in the example of FIGS. 27 and 28.

FIG. 29 is a flowchart showing a process flow of Step S330. The processes in FIG. 29 equivalent to those in FIG. 26 are denoted at the same step numbers. When the process of Step S330 is initiated, the message discriminating section 315 reads out the message 306 from the log memory 420 (Step S341). Then, the message discriminating section 315 judges the state of the process flag (Step S342). If the process flag indicates that the process by the message discriminating section 322 of the master microcomputer 400 has been completed (YES in Step S342), the process of Step S330 with respect to the instant message 306 is terminated. If the process flag indicates that the process has not been completed (NO in Step S342), it is judged whether the difference in time between the current time and the time stamped on the message 306 is within the effective term described in the database (Step S343). If the judgment result is affirmative (YES in Step S343), the message discriminating section 325 terminates the process of Step S330 with respect to the message 306.

Subsequently, the message discriminating section 315 judges whether recreation of the message 306 is necessary by referring to the database stored in the database memory 314 (Step S352). If recreation is not necessary (NO in Step S352), the process of Step S330 is terminated. If recreation is necessary (YES in Step S352), the message discriminating section 315 causes the message creating section 311 to create a message 306 (Step S353). The recreated message 306 is sent to the master microcomputer 400 by the message sending section 312 (Step S354), and is processed by the message processing section 322. Thus, the process of Step S330 is terminated. The message discriminating section 315 may individually execute the processes of Steps S341 through S354 with respect to each of the messages 306 recorded in the log memory 420, or may integrally execute the readout process of Step S341, and execute the processes of Steps S342 through S354 with respect to each of the read-out messages 306 after the integral read-out process.

Referring back to FIG. 24, when the process of Step S330 is completed, the microcomputer system 390 is resumed to the ordinary processes (Steps S320, S321, S322). The message 306 constituted of a notification that the process of the unprocessed message in the master microcomputer 400 has been completed may be sent to the other microcomputers, namely, to the master microcomputer 400 and the sub microcomputer 402 by the message sending section 312.

The microcomputer system 390 is operated as mentioned above. In this arrangement, the master microcomputer 400 can process the message 306 as it is that is processable without recreation, and can process the new message 306 that reflects the new status after restart of the master microcomputer 400 instead of processing too old message 306, if the message 306 is left unprocessed in the master microcomputer 400 during suspension of the operation of the master microcomputer 400. Further, a new message is created with respect only to the message that is to be recreated, by referring to the database. This arrangement makes it possible to save time required for implementing an unnecessary process with respect to the unprocessed message whose effective term has lapsed.

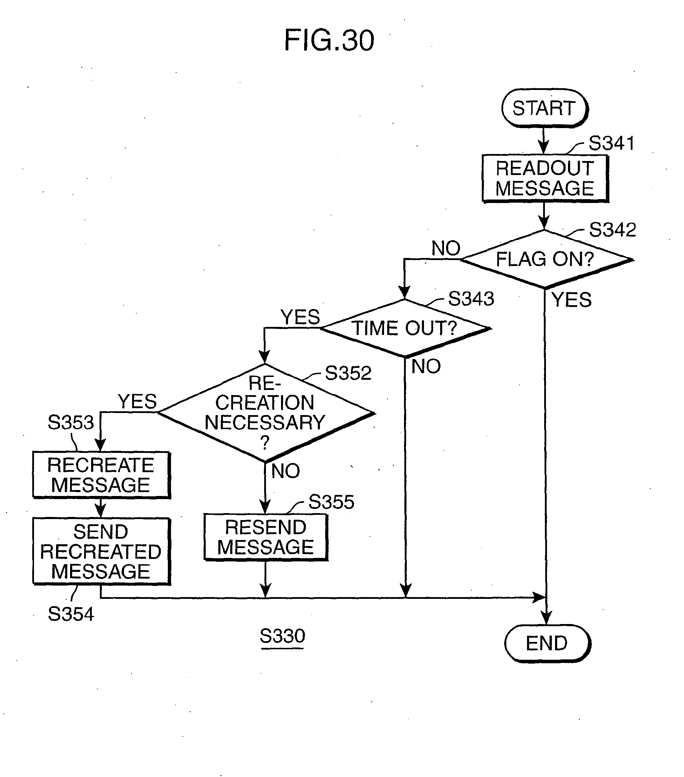

The message discriminating section 315 may implement the process of Step S330 shown in the example of FIG. 30, in place of implementing the process of Step S330 shown in the example of FIG. 29. The process shown in FIG. 30 is different from that shown in FIG. 29 in that the message 306 with respect to which recreation is judged to be unnecessary in Step S352 is sent to the master microcomputer 400 as it is by the message sending section 312 (Step S355). The message discriminating section 315 causes the message creating section 311 to create a new message 306 that reflects the new status, by referring to the database as shown in the example of FIG. 28, in the case where the unprocessed message 306 is constituted of a notification notifying the opened/closed state of the door of the refrigerator 501, and the contents of the unprocessed message regarding the opened/closed state of the door of the refrigerator 501 are different from the current status after restart of the master microcomputer 400 (Step S353). On the other hand, in the case where the contents of the unprocessed message are identical to the current status after restart of the master microcomputer 400, the message discriminating section 315 causes the message sending section 312 to send the unprocessed message 306 to the message receiving section 321 of the master microcomputer 400 (Step S355). This arrangement makes it possible to save time required for creating an unnecessary new message, and to cause the message processing section 322 of the master microcomputer 400 to implement a proper process with respect to the unprocessed message 306 whose effective term has lapsed.

### (Process of unprocessed message after restart of sub microcomputer)

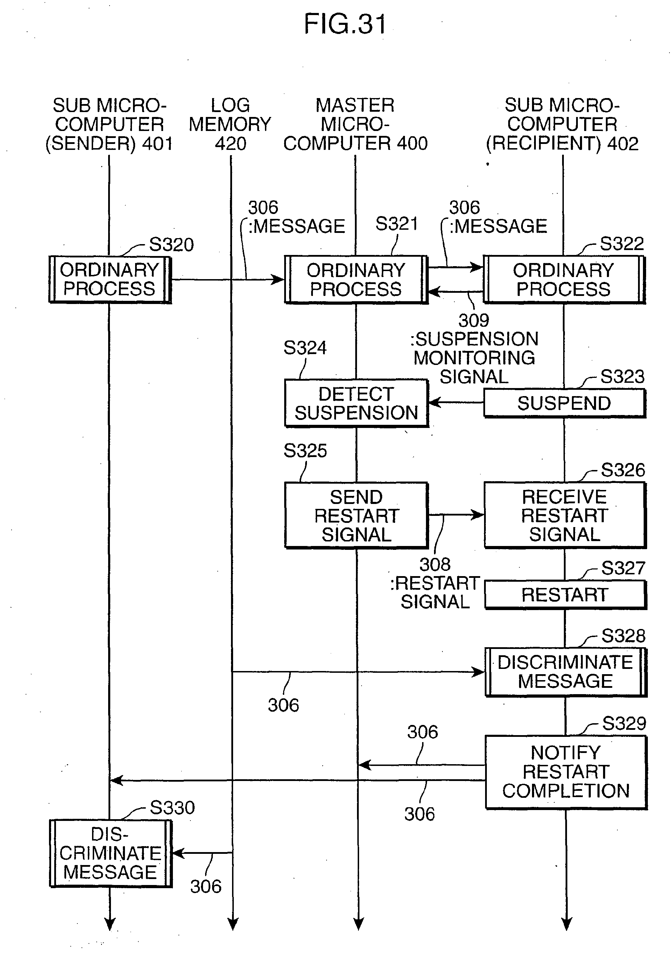

Now, a procedure as to how the unprocessed message is processed after restart of the sub microcomputer 402, referring to the block diagram in FIG. 21 and the flowchart in FIG. 31. The processes in FIG. 31 equivalent to those in FIG. 24 are denoted at the same step numbers. While the ordinary processes (Steps S320, S321, and S322) are implemented, a state of the sub microcomputer 402 is monitored as to whether the operation of the sub microcomputer 402 is suspended. Monitoring of the suspension of the operation of the sub microcomputer 402 is carried out by the master microcomputer 400 in the example of FIG. 31.

When the operation of the sub microcomputer 402 is suspended due to a cause such as an erroneous operation of the hardware (Step S323), the master microcomputer 400 detects the suspension of the operation (Step S324), and sends the restart signal 308 to the sub microcomputer 402 (Step S325). When the restart signal receiving section 336 of the sub microcomputer 402 receives the restart signal 308 (Step S326), the operation of the sub microcomputer 402 is restarted (Step S327). Subsequently, the message discriminating section 335 of the sub microcomputer 402 judges whether the message 306 (including an unprocessed message) recorded in the log memory 420 is to be processed, and implements a necessary process (Step S328). The process of Step S328 is implemented by referring to the database stored in the database memory 334 of the sub microcomputer 402. The contents of the database stored in the database memory 334 are the same as those shown in FIG. 25.

The process of Step S328 is illustrated in the flowchart of FIG. 26. Specifically, when the process of Step S328 is initiated, the message discriminating section 335 of the sub microcomputer 402 reads out the message 306 from the log memory 420 (Step S341). Then, the message discriminating section 335 judges the state of the process flag attached to the message 306 (Step S342). If the process flag indicates that the process by the message processing section 332 of the sub microcomputer 402 has been completed (YES in Step S342), the process of Step S328 with respect to the message 306 is terminated. If the process flag indicates that the process has not been completed (NO in Step S342), it is judged whether the difference in time between the current time and the time stamped on the message 306 is within the effective term described in the database (Step S343). If the judgment result is affirmative (YES in Step S343), the message discriminating section 335 causes the message processing section 332 to implement the process with respect to the message 306 (Step S344). The message discriminating section 335 may individually execute the processes of Steps S341 through S344 with respect to each of the messages 306 recorded in the log memory 420, or may integrally execute the readout process of Step S341, and execute the processes of Steps S342 through S344 with respect to each of the read-out messages 306 after the integral read-out process.

Referring back to FIGS. 21 and 31, when the process of Step S328 is completed, the sub microcomputer 402 sends the message 306 constituted of a notification that restart of the sub microcomputer 402 has been completed to the other microcomputers, namely, to the master microcomputer 400 and the sub microcomputer 401 by the message processing section 332 (Step S329). The other microcomputers can be notified that restart of the sub microcomputer 402 has been completed by receiving the restart completion notification. For instance, when the sub microcomputer 401 receives the restart completion notification from the sub microcomputer 402 by a message receiving section (not shown), the message discriminating section 315 of the sub microcomputer 401 judges whether the message 306 recorded in the log memory 420 is to be processed, and implements a necessary process (Step S330). The process of Step S330 is exemplified in FIG. 29 or FIG. 30. Similarly to the process after restart of the master microcomputer 400 (see FIG. 24), the contents of the database 314 of the sub microcomputer 401 which are referred to in Step S330 are exemplified in FIGS. 25, 27, and 28. After the process of Step S330 is completed, the sub microcomputer 401 may send the message 306 constituted of a notification that the unprocessed message in the sub microcomputer 402 has been processed to the other microcomputers, namely, to the master microcomputer 400 and the sub microcomputer 402 by the message sending section 312.

In this way, the above arrangement makes it possible to carry out a proper process after restart of the sub microcomputer 402 with respect to the message 306 that has been left unprocessed during suspension of the operation of the sub microcomputer 402.

### (Various arrangements on monitoring operation suspension)

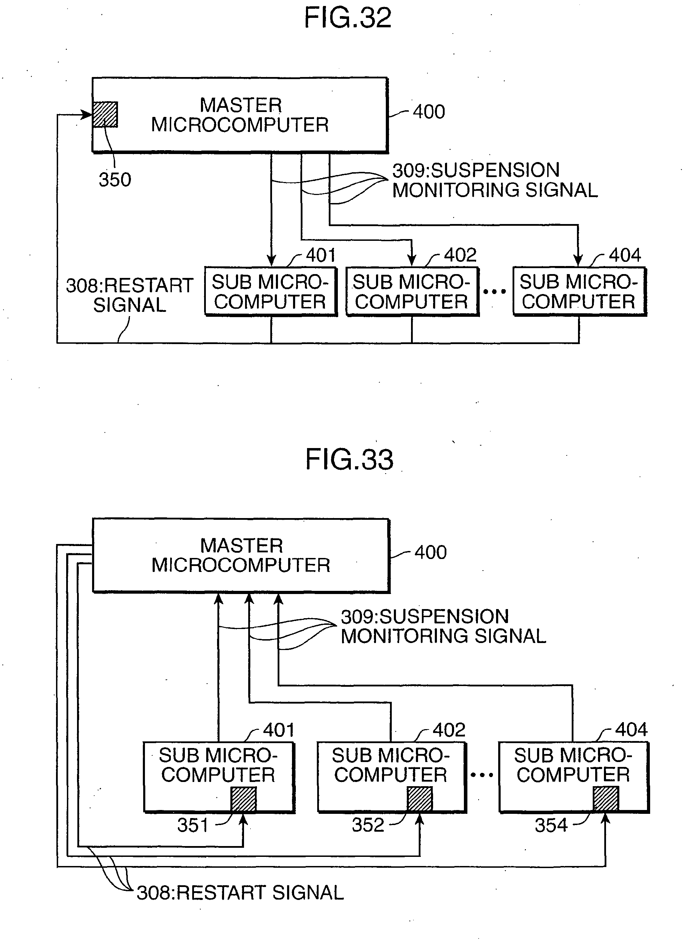

There are proposed various arrangements of monitoring suspensions of the operations of the master microcomputer 400 and the sub microcomputers 401, 402, 403, 404, and restarting the operations thereof when the operations are suspended. In the example of FIG. 32, when each of the sub microcomputers 401, 402, 403, 404 monitors the suspension of the operation of the master microcomputer 400 by using the suspension monitoring signal 309, and one of the sub microcomputers 401, 402, 403, 404 detects suspension of the operation of the master microcomputer 400, the sub microcomputer that has detected the suspension sends the restart signal 308 to the master microcomputer 400. When the restart signal 308 is inputted to a reset register 350 in the CPU 301 (see FIG. 20) of the master microcomputer 400, the CPU 301 is restarted. Alternatively, one of the sub microcomputers 401, 402, 403, 404 may monitor suspension of the operation of the master microcomputer 400, in place of the arrangement that each of the sub microcomputers 401, 402, 403, 404 monitors the operation of the master microcomputer 400.

In the example of FIG. 33, the master microcomputer 400 monitors suspensions of the operations of the sub microcomputers 401, 402, 403, 404 by using the suspension monitoring signal 309. When the master microcomputer 400 detects suspension of the operation of one of the sub microcomputers 401, 402, 403, 404, the master microcomputer 400 sends the restart signal 308 to the sub microcomputer of which suspension of the operation has been detected. When the restart signal 308 is sent to the reset register 351 (352, 353, or 354) of the sub microcomputer 401 (402, 403, or 404), the CPU 301 of the sub microcomputer that has received the restart signal 308 is restarted.

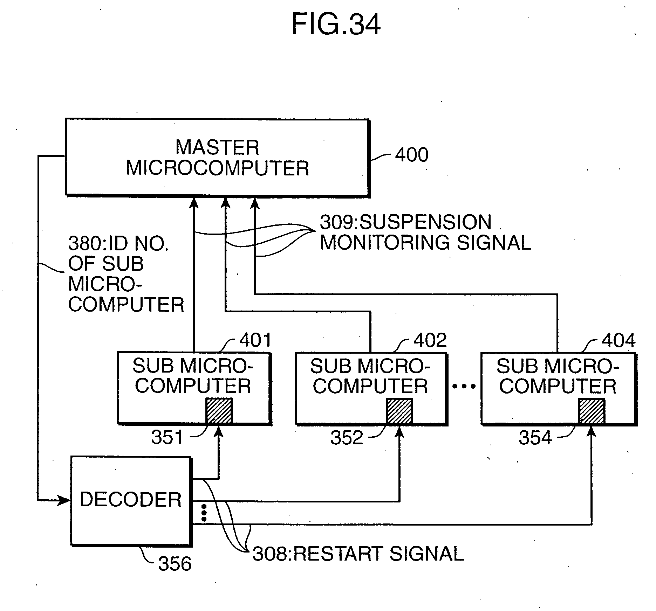

In the example of FIG. 34, the master microcomputer 400 monitors suspensions of the operations of the sub microcomputers 401, 402, 403, 404 by using the suspension monitoring signal 309. When the master microcomputer 400 detects suspension of the operation of one of the sub microcomputers 401, 402, 403, 404, the master microcomputer 400 sends, to a decoder 356, ID No. 380 identifying the sub microcomputer of which suspension of the operation has been detected. The decoder 356 sends the restart signal 308 to one of the sub microcomputers 401, 402, 403, 404 identified by the ID No. 380 by decoding the ID No. 380. The arrangement shown in FIG. 34 makes it possible to minimize the number of output ports for sending the restart signal 308, and the number of wirings for transmitting the restart signal 308.

As compared with the arrangement disclosed in D2 in which a suspension signal is inputted manually by a user based on recognition that the operation of the device is suspended, the operation suspended period can be shortened in the arrangements shown in FIGS. 32 through 34, because the arrangements in FIGS. 32 through 34 are configured in such a manner that the microcomputers mutually monitor suspensions of the operations of the microcomputers other than the self microcomputer, and send the restart signal to the microcomputer of which suspension of the operation has been detected. With this arrangement, the microcomputer system 390 is applicable to an apparatus such as a refrigerator, in which a long-term cooling suspended operation is prohibited, and to a security device, such as a sensor of detecting and alerting suspicious individuals, and a sensor of detecting and alerting a fire, in which even a short-term suspended operation is prohibited. Further, since the microcomputers mutually monitor suspensions of the operations thereof, there is no need of additionally providing a device of monitoring the operation of the microcomputers, whereby the microcomputer system 390 can be produced with a low cost.

### [Fifth embodiment]

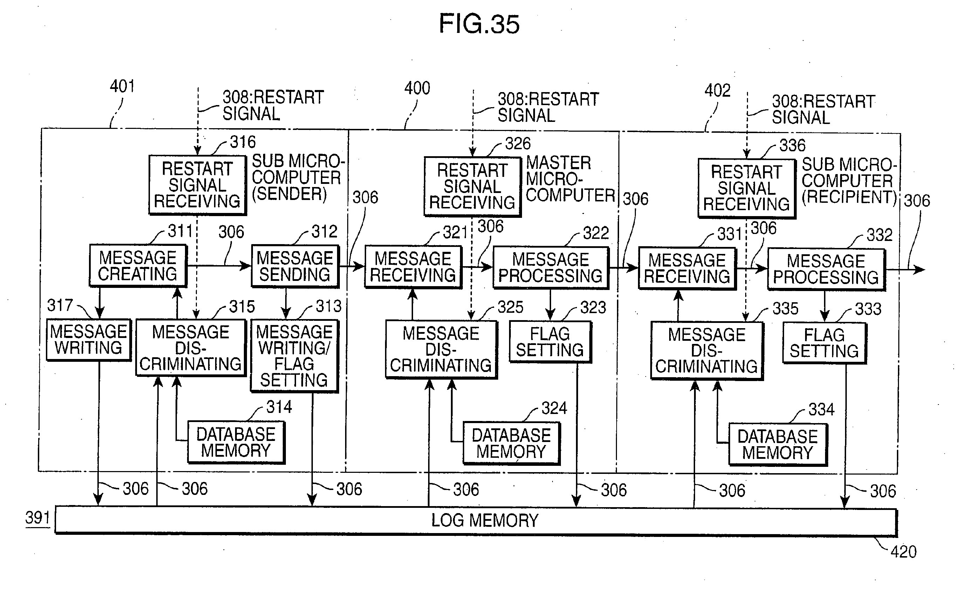

FIG. 35 is a block diagram depicted based on a function of a microcomputer system (see FIG. 19) in accordance with a fifth embodiment of the present invention. Similarly to CPUs 301 of a master microcomputer 400 and a sub microcomputer 402, a CPU 301 of a sub microcomputer 401 implements various processes. Accordingly, a stand-by time is generated in the ordinary process of the CPU 301 of the sub microcomputer 401 until a process by a message sending section 312 is performed after a message creating section 311 of the sub microcomputer 401 creates a message 306. As a result, if the operation of the CPU 301 of the sub microcomputer 401 is suspended, the message 306 is left unprocessed in a log memory 420 because the stand-by time has not lapsed. The operation of the sub microcomputer 401 including a database memory 314 is suspended if the operation of the CPU 301 of the sub microcomputer 401 is suspended.

The microcomputer system 391 shown in the example of FIG. 35 is configured in such a manner that processing of a message that is left unprocessed in the sub microcomputer 401 by suspension of the operation of the sub microcomputer 401 is executable. Specifically, the microcomputer system 391 is different from the microcomputer system 390 shown in the example of FIG. 21 in that the sub microcomputer 401 in the microcomputer system 391 is provided with a message writing section 317 and a restart signal receiving section 316.

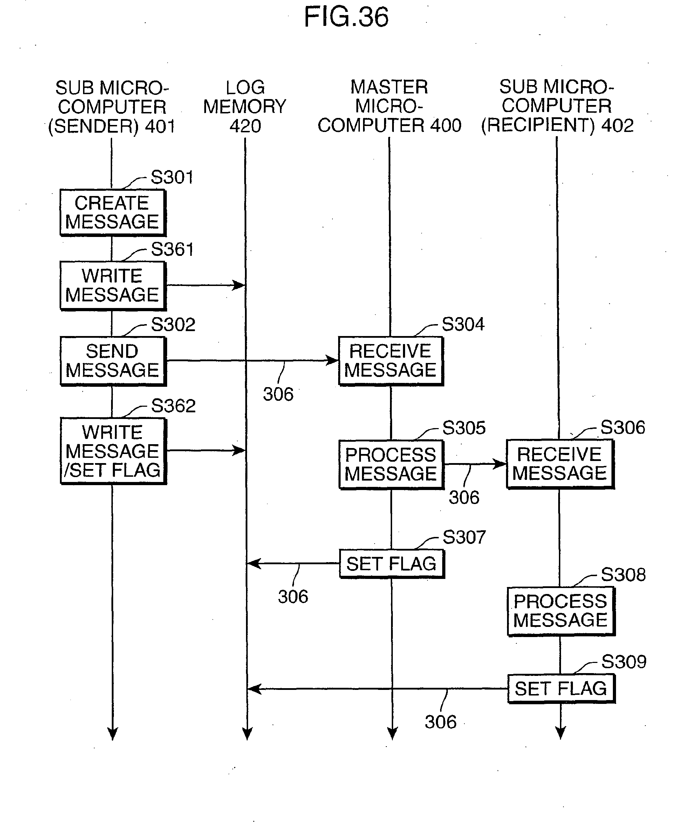

FIG. 36 is a flowchart showing a process flow of ordinary operations of the master microcomputer 400, and the sub microcomputers 401, 402 in the microcomputer system 391. Processes in FIG. 36 equivalent to those in FIG. 22 are denoted at the same step numbers. When the ordinary operation is initiated, the message creating section 311 of the sub microcomputer 401 creates the message 306 (Step S301). Then, the message writing section 317 records the created message 306 in the log memory 420 (Step S361). At this time, the process flag (see FIG. 23) indicates that the message 306 is unprocessed. The created message 306 is sent to the master microcomputer 400 by a message sending section 312 (Step S302). When transmission of the message 306 is completed, a message writing section 313 of the sub microcomputer 401 sets the process flag indicating that the message 306 has been processed, and records the message 306 in the log memory 420 (Step S362). Specifically, similar to flag setting sections 323 and 333 of the master microcomputer 400 and the sub microcomputer 402, the message writing section 313 of the sub microcomputer 401 in the microcomputer system 391 functions as a component of setting the process flag indicating that the message transmission by the message sending section 312 of the sub microcomputer 401 has been completed with the respect to the message 306 recorded in the log memory 420.

On the other hand, a message receiving section 321 of the master microcomputer 400 receives the message 306 (Step S304). A message processing section 322 processes the received message 306 depending on the contents of the message 306 (Step S305). When the process by the message processing section 322 is completed, the flag setting section 323 sets the process flag indicating that the message 306 has been processed, and records the message 306 in the log memory 420 (Step S307).

In the case where the message 306 is to be sent to the sub microcomputer 402, the message processing section 322 of the master microcomputer 400 sends the message 306 to the sub microcomputer 402 (Step S305). Then, the message receiving section 331 of the sub microcomputer 402 receives the message 306 (Step S306). The message processing section 332 processes the message 306 depending on the contents of the message 306 (Step S308). When the process by the message processing section 332 is completed, the flag setting section 333 sets the process flag indicating that the message 306 has been processed, and records the message in the log memory 420 (Step S309). Specifically, in the examples of FIGS. 35 and 36, in the case where the message 306 is to be sent to the sub microcomputer 402, there are used three different kinds of flags, as the process flag: a flag for judging whether the message transmission by the sub microcomputer 401 has been completed; a flag for judging whether the message relay transmission by the master microcomputer 400 has been completed; and a flag for judging whether the process by the sub microcomputer 402 as the recipient has been completed. In this way, the log on processes of the message 306 is recorded in the log memory 420.

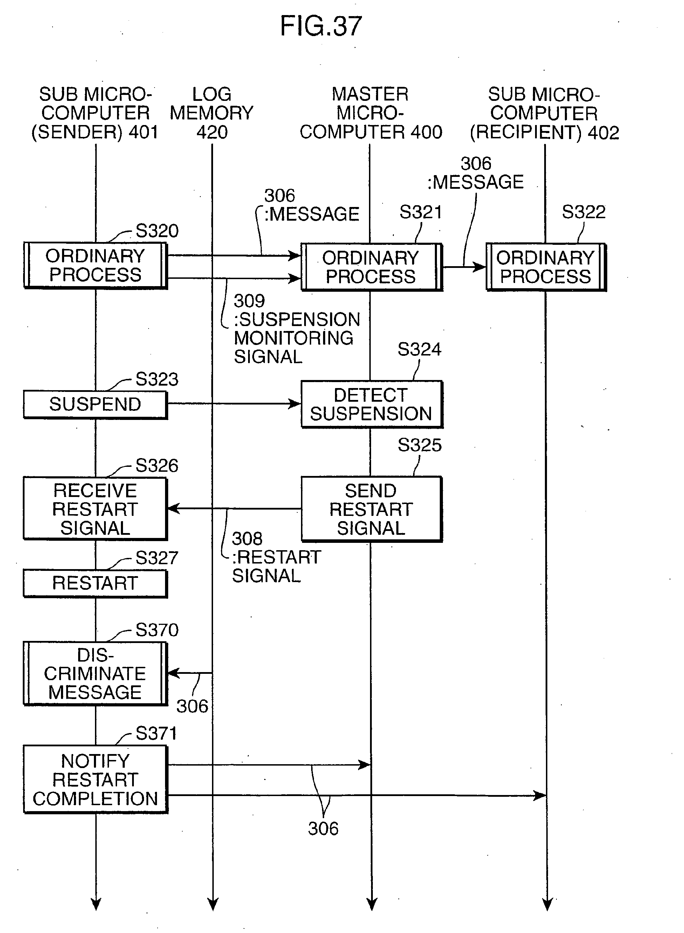

Now, a procedure as to how an unprocessed message is processed after restart of the sub microcomputer 401 is described referring to the block diagram in FIG. 35 and the flowchart in FIG. 37. Processes in FIG. 37 equivalent to those in FIG. 24 are denoted at the same step numbers. While the ordinary processes (Steps S320, S321, and S322) are implemented, a state is monitored as to whether the operation of the sub microcomputer 401 is suspended. Monitoring of the suspension of the operation of the sub microcomputer 401 is executed by the master microcomputer 400 in the example of FIG. 37.

Next, when the operation of the sub microcomputer 401 is suspended due to a cause such as an erroneous operation of the hardware (Step S323), the master microcomputer 400 detects the suspension of the operation of the sub microcomputer 401 (Step S324), and sends the restart signal 308 to the sub microcomputer 401 (Step S325). When the restart signal receiving section 316 of the sub microcomputer 401 receives the restart signal 308 (Step S326), the operation of the sub microcomputer 401 is restarted (Step S327). Subsequently, a message discriminating section 315 of the sub microcomputer 402 judges whether the message 306 recorded in the log memory 420 is to be processed, and implements a necessary process (Step S370). The process of Step S370 is implemented by referring to the database stored in the database memory 314 of the sub microcomputer 401. Examples of the database stored in the database memory 314 is as shown in FIGS. 25, 27, and 28.

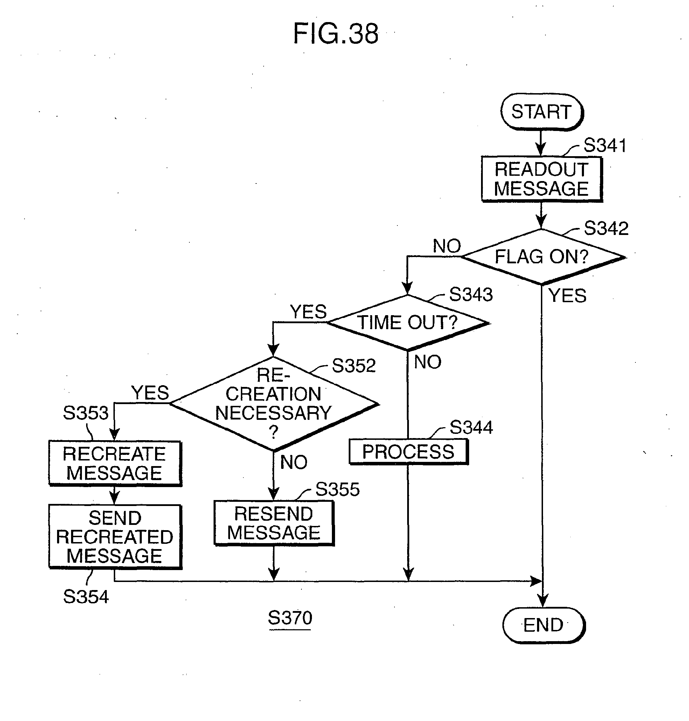

The process of Step S370 is exemplified in the flowchart of FIG. 38. Processes in FIG. 38 equivalent to those in FIGS. 26 and 30 are denoted at the same step numbers. When the process of Step S370 is initiated, the message discriminating section 315 of the sub microcomputer 401 reads out the message 306 from the log memory 420 (Step S341). Then, the message discriminating section 315 judges the state of the process flag attached to the message 306 (Step S342). If the process flag indicates that the message 306 has been processed (YES in Step S342), the process of Step S370 with respect to the message 306 is terminated. If the process flag indicates that the message 306 has not been processed (NO in Step S342), it is judged whether a difference in time between the current time and the time stamped on the message 306 is within the effective term described in the database stored in the database memory 314 (Step S343). If the time difference is within the effective term (NO in Step S343), the message discriminating section 315 causes the message sending section 312 to send the message 306 to the message receiving section 321 of the master microcomputer 400 (Step S344).

Subsequently, the message discriminating section 315 judges whether recreation of the message 306 is necessary, by referring to the database stored in the database memory 314 (Step S352). If recreation is not necessary (NO in Step S352), the message discriminating section 315 causes the message sending section 312 to send the message 306 to the master microcomputer 400 as it is (Step S355). Alternatively, as shown in FIG. 29, if it is judged that recreation is not necessary (NO in Step S352), the process of Step S370 may be terminated.

If, on the other hand, recreation is necessary (YES in Step S352), the message discriminating section 315 causes the message creating section 311 to create a message 306 (Step S353). The recreated message 306 is sent to the master microcomputer 400 by the message sending section 312 (Step S354), and processed by the message processing section 322. Thus, the process of Step S370 is terminated. The message discriminating section 315 may individually execute the processes of Steps S341 through S355 with respect to each of the messages 306 recorded in the log memory 420, or may integrally execute the readout process of Step S341, and execute the processes of Steps S342 through S355 with respect to each of the read-out messages 306 after the integral read-out process.

Referring back to FIG. 37, when the process of Step S370 is completed, the sub microcomputer 401 sends the message 306 constituted of a notification notifying restart completion to the other microcomputers, namely, to the master microcomputer 400, and the sub microcomputer 402 by the message sending section 312 (Step S371). The other microcomputers can be notified that the restart of the sub microcomputer 401 has been completed by receiving the notification. When the process of Step S371 is completed, the microcomputer system 391 is resumed to the ordinary processes (Steps S320, S321, S322).

The microcomputer system 391 is operated as mentioned above. This arrangement makes it possible to cause the message recipient to carry out a proper process with respect to the message which has been left unprocessed during suspension of the operation of the sub microcomputer 401. Similarly to the arrangement of the microcomputer system 390, the microcomputer system 391 enables to process the unprocessed message after restart of the master microcomputer, and process the unprocessed message after restart of the sub microcomputer 402.

### [Sixth Embodiment]

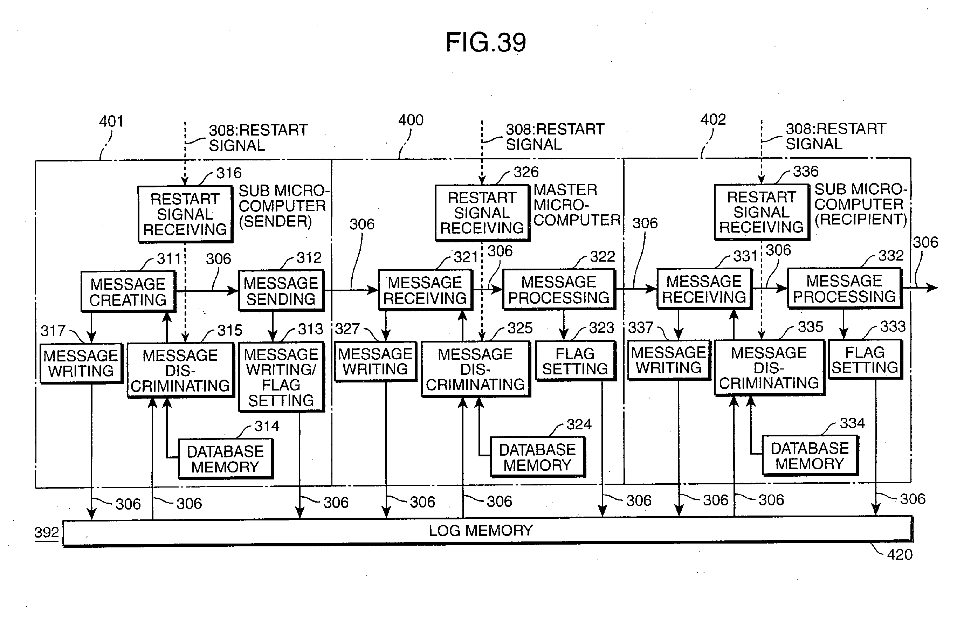

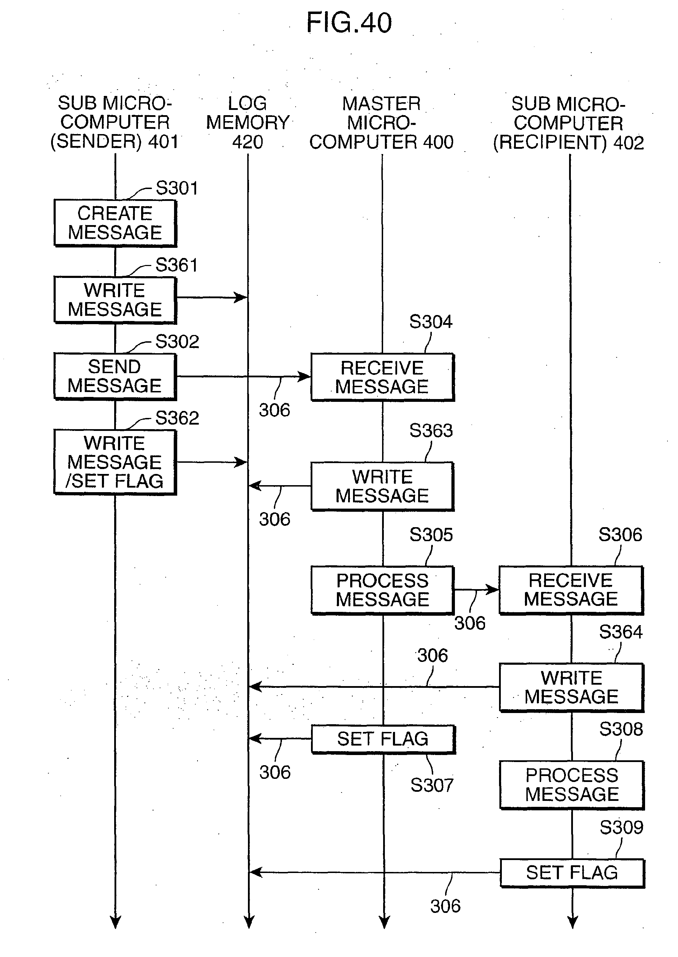

FIG. 39 is a block diagram depicted based on a function of a microcomputer system (see FIG. 19) in accordance with a sixth embodiment of the present invention. The microcomputer system 392 is different from the microcomputer system 391 shown in FIG. 35 in that a master microcomputer 400 is provided with a message writing section 327, and a sub microcomputer 402 is provided with a message writing section 337. FIG. 40 is a flowchart showing a process flow in ordinary operations of the master microcomputer 400 and the sub microcomputers 401, 402 of the microcomputer system 392. Processes in FIG. 40 equivalent to those in FIGS. 22 and 36 are denoted at the same step numbers.

When the ordinary operation is initiated, a message creating section 311 of the sub microcomputer 401 creates a message 306 (Step S301). Then, a message writing section 317 records the created message 306 in a log memory 420 (Step S361). At this time, the process flag (see FIG. 23) indicates that the message 306 is unprocessed. The created message 306 is sent to the master microcomputer 400 by a message sending section 312 (Step S302). When transmission of the message 306 is completed, a message writing section 313 of the sub microcomputer 401 sets the process flag indicating that the message 306 has been processed, and records the message 306 in the log memory 420 (Step S362). Specifically, similar to the arrangement of the microcomputer system 391, in the microcomputer system 392, the message writing section 313 functions as a component of setting the process flag indicating that the message transmission by the message sending section 312 of the sub microcomputer 401 has been completed with the respect to the message 306 recorded in the log memory 420.

On the other hand, a message receiving section 321 in the master microcomputer 400 receives the message 306 (Step S304). The message writing section 327 records the received message 306 in the log memory 420 (Step S363). In other words, the new message 306 is recorded in the log memory 420, in addition to the message 306 with its process flag being attached thereto by the message writing section 313 of the sub microcomputer 401. In Step S363, the process flag of the new message 306 which has been recorded in the log memory 420 indicates that the message 306 is unprocessed.

The message processing section 322 processes the received message 306 depending on the contents of the message 306 (Step S305). When the process by the message processing section 322 is completed, a flag setting section 323 sets the flag indicating that the message 306 has been processed, and records the message 306 in the log memory 420 (Step S307). In other words, the process flag of the message 306 which has been newly recorded in the log memory 420 in Step S363 indicates that the message 306 has been processed in Step S307.

In the case where the message 306 is to be sent to the sub microcomputer 402, the message processing section 322 of the master microcomputer 400 sends the message 306 to the sub microcomputer 402 (Step S305). Then, the message writing section 337 of the sub microcomputer 402 records the message 306 received by the message receiving section 331 in the log memory 420 (Step S364). In other words, the new message 306 is recorded in the log memory 420, in addition to the message 306 with the process flag indicating that the message 306 has been processed by the message writing section 313 of the sub microcomputer 401, and the message 306 with the process flag indicating that the message 306 has been processed by the flag setting section 323 of the master microcomputer 400. In Step S364, the process flag of the newly recorded message 306 indicates that the message 306 is unprocessed. The message processing section 332 processes the received message 306 depending on the contents of the message 306 (Step S308). When the process by the message processing section 332 is completed, a flag setting section 333 sets the flag indicating that the message 306 has been processed, and records the message 306 in the log memory 420 (Step S309).

Specifically, in the examples of FIGS. 39 and 40, in the case where the message 306 is to be sent to the sub microcomputer 402, there are recorded three different kinds of messages 306 in the log memory 420 with three different kinds of process flags being attached thereto: a flag for judging whether the message transmission by the sub microcomputer 401 has been completed; a flag for judging whether the message relay transmission by the master microcomputer 400 has been completed; and a flag for judging whether the process by the sub microcomputer 402 as the recipient has been completed. In this way, the log on processes of the message 306 is recorded in the log memory 420.

In this way, the microcomputer system 392 stores information of a large capacity, as log information on the message 306, as compared with the microcomputer systems 390 and 391. Accordingly, the microcomputer system 392 requires the largest capacity as a memory capacity of the log memory 420 among the microcomputer systems 390 through 392. Nevertheless, similarly to the arrangement of the microcomputer system 391, the microcomputer system 392 is capable of executing the processes with respect to the unprocessed message after restart of the microcomputer, as exemplified in FIGS. 24, 26, 29, 30, 31, 37, and 38.

### [Seventh Embodiment]

As stated above, in the apparatus controlling device 107 according to the second embodiment (shown in FIGS. 12 and 13), the CPU 1b, after restarted, updates the contents in a register 21b to the latest contents in a register 21a (Step S18 of FIG. 14). It is normal that the register 21b is reset to initialize the contents thereof to the default values when the CPU 1b is restarted. For this reason, it is required that the contents of the register 21b is updated to the latest contents after the CPU 1b is restarted.

In order to update the contents of the register 21b to the latest contents, the detecting section 37 can be configured to write the statuses, such as the internal temperature of the refrigerator 202 detected by the temperature sensor 106 in the register 21b. As to the set conditions, such as the set temperature of the refrigerator 202, the communicating section 109 can be configured to send the set conditions to the controlling section 108. As stated above, the contents stored in the register 21b are conveyed to the register 21a by way of the message 6 as the internal notification. The internal notification can include the notification of the set conditions stored in the register 21b. Thereby, when the CPU 1b is restarted, the set conditions stored in the register 21b can be conveyed to the register 21b so that the set conditions stored in the register 21b is updated to the latest contents.

More specifically, the message creating section 48 reads the set condition or set conditions out of data stored in the register 21b and creates a message or messages 6 based on the read out data. The created messages 6 are sent through the message memory 3a to the controlling section 108 by the message sending section 32. The sent messages 6 are received by the message receiving section 34. The received messages 6 are written in the register 21b through the message memory 3a by the writing section 35.

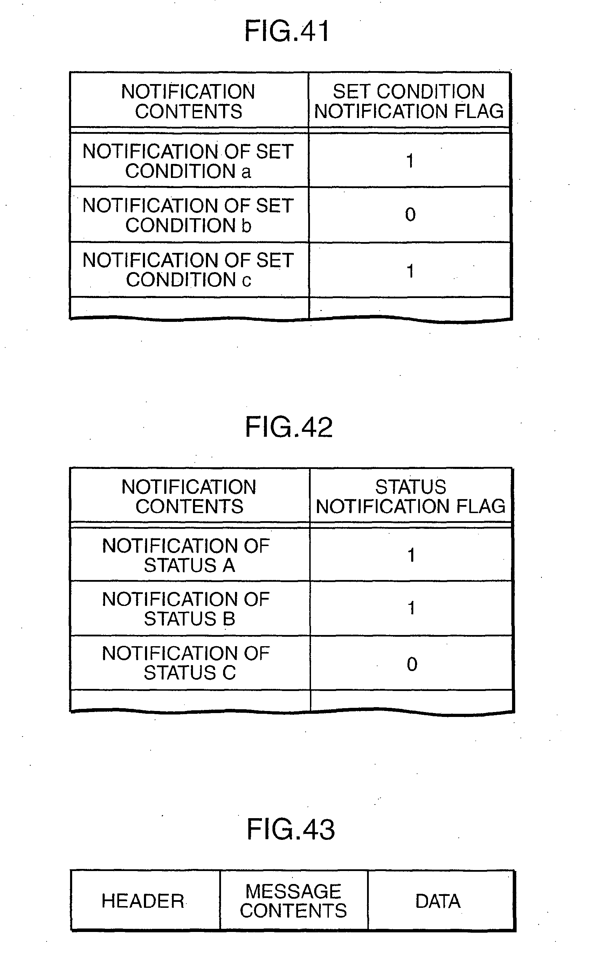

There may be some of set conditions that does not require or rather prohibit the default value of the register 21b to be updated thereto. Therefore, it is preferable that the communicating section 109 has the discrimination database memory 4a like the communicating section 103 shown in FIG. 4 and the discrimination database memory 4a stores a database exemplarily shown in FIG. 41. The database illustrated in FIG. 41 describes a set condition notification flag for each kind of set conditions that defines whether the corresponding set condition is to be notified or not. The message sending section 32 preferably refers to the database stored in the discrimination database memory 4a, selects the set condition or set conditions for which the set condition notification flag is set at "1" from the register 21a, and sends the selected set conditions to the controlling section 108.

As stated above, in the apparatus controlling device 101 according to the first embodiment (shown in FIGS. 3 and 4), after the CPU 1a is restarted (Step S16 in FIG. 9), the controlling section 102 sends the contents in the register 21b to the communicating section 103 to thereby update the contents in a register 21a to the latest contents in a register 21b (Step S18 of FIG. 9). It is normal that the register 21a is reset to initialize the contents thereof to the default values when the CPU 1a is restarted. For this reason, it is required that the contents of the register 21a is updated to the latest contents after the CPU 1a is restarted.

The updated contents in the register 21a include the status or statuses of the components such as the temperature sensor 106 to be controlled, e.g., the internal temperature of the refrigerator 201. There is possibility that the latest statuses of the components to be controlled stored in the register 21a is not identical to the statuses that the controller 110 has already acquired when the CPU 1a is restarted after suspension of the operation. It is, therefore, preferable that the communicating section103 notifies the latest statuses of the components stored in the register 21a to the controller 110.

More specifically, the message creating section 48 reads the status or statuses of the components out of the updated latest contents stored in the register 21a and creates a message 6 or messages 6 based on the read out data. The created messages 6 are sent through the message memory 3a and the protocol converting section 43 to the controller 110 by the message sending section 44.

There may be some of statuses of the components that does not require or rather prohibit the default value of the register 21a to be updated thereto. Therefore, it is preferable that the discrimination database memory 4a stores a database exemplarily shown in FIG. 42. The database illustrated in FIG. 42 describes a status notification flag for each kind of statuses of the components to be controlled that defines whether the corresponding status is to be notified or not. The message sending section 48 preferably refers to the database stored in the discrimination database memory 4a, selects the status or statuses for which the status notification flag is set at "1" from the register 21a.

As stated above as the third embodiment, both the first and the second embodiments can be laid into practice simultaneously. In this case, the discrimination database memory 4a preferably stores both the databases illustrated in FIGS 41 and 42.

It is preferable to enable the controller 110 to set the set condition notification flags and the status notification flags. Therefore, the controller 110 is preferably configured to send the message or messages 6 having a data structure exemplarily shown in FIG. 43 to the apparatus controlling device 101. 107, 115 or 120. In FIG. 43, the header includes codes identifying the sender (i.e. the controller 110) and the recipient (i.e. the apparatus controlling device 101 and others). The message content is the information that specifies the kind of the notifications illustrated in FIGS. 41 and 42. The data includes the set condition notification flag and the status notification flag. As another example of the data structure shown in FIG. 43, the message content may show which of the notification of the set condition or the notification of the status the message 6 is for, and the data may show a notification content for which the set condition notification flag is to be set at "1" (e.g., notification of the set condition "a") or a notification content for which the status notification flag is to be set at "1" (e.g., notification of the status "A"). Further, the data in one message 6 may show two or more notification contents simultaneously for which the flag is to be set at "1." In this case, the data may specify the notification contents for which the flag is to be set at "1" among predetermined plural notification contents in the form of bit map.

In an example of the apparatus controlling device 101 shown in FIG. 4, the controller 110 preferably sends the message 6 illustrated in FIG. 43 to the apparatus controlling device 101 immediately after the apparatus controlling device 101 is connected through the communications line L to the controller 110. The sent out message 6 is received by the message receiving section 30. The received message 6 is stored in the discrimination database memory 4a as a database through the protocol converting section 31 and the message memory 3a by the writing section 46.

### [Other Embodiments]

In the above-stated first to third and seventh embodiments, the registers 21a and 21b are provided within the CPU 1a and 1b, respectively. Each of the registers 21a and 21b can, however, be configured as another storing medium such as an RAM (Random Access Memory) separated from the CPU 1a and 1b.

### [Brief Description on the Embodiments]

The following is a brief description on the embodiments of the present invention.

(1) A message processor for implementing a process by communicating a message with an external device, comprises: message generating means including at least one of message receiving means to receive the message from the external device, and message creating means to create the message; message storing means to store the message received or created by the message generating means; message processing means to read out the message stored in the message storing means and to implement a process based on the message; identification code attaching means to record, in the message storing means, the message processed by the message processing means with an identification code indicating that the message has been processed being attached thereto; discrimination database storing means to store a database describing an effective term with respect to each of contents of the message; and message discriminating means to read out the message from the message storing means in response to a restart signal received in the message processor after the operation of the message processor is suspended, and to cause the message processing means to implement the process with respect to the message to which the identification code has not been attached and whose effective term has not lapsed, among the readout message, by referring to the database.

In the message processor (1), the message stored in the message storing means is read out therefrom in response to the restart signal received in the message processor after the operation of the message processor is suspended, and the process is implemented with respect to the unprocessed message whose effective term has not lapsed, by referring to the database stored in the discrimination database storing means. This arrangement makes it possible to process the message which has been left unprocessed during suspension of the operation of the message processor, and to save time required for implementing an unnecessary process with respect to an unprocessed message whose effective term has lapsed.

It is possible to, as exemplary processes by the message processor (1), carry out an internal process such as sending the created message to the external device, sending the received message to the external device, or controlling the apparatus based on the received message, or selectively perform these processes based on the contents of the message.

(2) A message processor is the message processor (1), wherein: the message generating means includes the message creating means; the database further describes whether the message is to be recreated after lapse of the effective term with respect to each of the contents of the message created by the message creating means; and the message discriminating means causes the message creating means to recreate the message to which the identification code has not been attached, whose effective term has lapsed and which is to be recreated, among the message read out from the message storing means in response to the restart signal by referring to the database.

In the message processor (2), the message is recreated with respect to the unprocessed message whose effective term has lapsed by suspension of the operation of the message processor and which is to be recreated by referring to the database. This arrangement makes it possible to process the recreated message that reflects new status after restart of the message processor, in place of processing the message whose effective term has lapsed, and to save time required for implementing an unnecessary process.

(3) An apparatus controlling device is provided with a controlling section for controlling an apparatus by communicating a message with an external device via a communications line, and a communicating section which is provided between the controlling section and the communications line, and is adapted for performing protocol conversion of the message so as to interface with the controlling section and the communications line, wherein the communicating section includes: message receiving means to receive a first message sent through the communications line and a second message sent from the controlling section; message storing means to store the first message and the second message received by the message receiving means; message processing means to read out the first message and the second message stored in the message storing means, to send the readout first message to the controlling section, and to send the readout second message to the communications line; identification code attaching means to record, in the message storing means, the first message and the second message after the transmission by the message processing means, with the identification code indicating that the respective first and second messages have been processed being attached thereto; discrimination database storing means to store a database describing an effective term with respect to each of contents of the first message and the second message; and message discriminating means to read out the first message and the second message from the message storing means in response to a restart signal received in the communicating section after the operation of the communicating section is suspended, and to cause the message processing means to send the message to which the identification code has not been attached and whose effective term has not lapsed, among the readout first and second messages, by referring to the database.

In the apparatus controlling device (3), the message stored in the message storing means is read out therefrom in response to the restart signal received in the communicating section after the operation of the communicating section is suspended, and the unprocessed message whose effective term has not lapsed is sent by referring to the database stored in the discrimination database storing means. This arrangement makes it possible to send the message which was not sent during suspension of the operation of the communicating section, and to save time required for implementing an unnecessary process with respect to the unprocessed message whose effective term has lapsed. Further, since the communicating section having the protocol converting function and sharing a function or functions among a variety of kinds of apparatus controlling devices is provided independently of the controlling section, the entire design cost regarding the various kinds of apparatus controlling devices to be used in various kinds of apparatuses can be reduced.

(4) An apparatus controlling device is the device (3), wherein: the communicating section further includes message creating means to create a third message; the message storing means stores the third message created by the message creating means; the message processing means reads out the third message stored in the message storing means, sends the readout third message to the communications line, sends, to the controlling section, the readout first message except for one containing a data request to the controlling section, and causes the message creating means to create the third message responding to the first message containing the data request; identification code attaching means records, in the message storing means, the third message after the transmission by the message processing means, with the identification code indicating that the third message has been processed being attached thereto; the database describes an effective term with respect to each of contents of the third message; the message discriminating means reads out the third message from the message storing means in response to the restart signal, and causes the message processing means to send the message to which the identification code has not been attached and whose effective term has not lapsed, among the readout third message, by referring to the database; and the controlling section sends, to the communicating section, data required for the message creating section to create the third message responding to the data request contained by the first message.

In the apparatus controlling device (4), the communicating section creates and sends the third message, as a response to the data request, based on the data sent from the controlling section, in place of the controlling section, if the first message contains the data request. This arrangement alleviates the burden of the controlling section because the relatively heavy burden of the controlling section is shared by the communicating section, and accordingly, enhances responsiveness to the data request.

(5) An apparatus controlling device is the device (4), wherein the database further describes whether the third message is to be recreated after lapse of the effective term with respect to each of the contents of the third message; the message discriminating means causes the message creating means to recreate the third message to which the identification code has not been attached, whose effective term has lapsed, and which is to be recreated, among the third message read out from the message storing means in response to the restart signal by referring to the database; and the controlling section sends, to the communicating section, data required for the message creating section to recreate the third message after the operation of the communicating section is resumed in response to the restart signal.

In the apparatus controlling device (5), the message is recreated with respect to the third message which has been left unprocessed, whose effective term has lapsed due to suspension of the operation of the communicating section and which is to be recreated by referring to the database. This arrangement makes it possible to send the recreated third message that reflects new status after restart of the communicating section, in place of sending the third message whose effective term has lapsed, and to save time required for performing unnecessary transmission.

(6) An apparatus controlling device is the device (5), wherein the database further describes whether the second message is to be recreated after lapse of the effective term with respect to each of the contents of the second message; message discriminating means causes the message creating means to recreate the second message to which the identification code has not been attached, whose effective term has lapsed and which is to be recreated, as the third message, among the second message read out from the message storing means in response to the restart signal by referring to the database; and the controlling section sends, to the communicating section, data required for the message creating section to recreate the second message as the third message after the operation of the communicating section is resumed in response to the restart signal.

In the apparatus controlling device (6), the message is recreated and sent, as the third message, with respect to the second message which has been left unprocessed, whose effective term has lapsed and which is to be recreated, as well as the third message. This arrangement makes it possible to send the recreated message that reflects new status after restart of the communicating section, in place of sending the unprocessed second message whose effective term has lapsed, and to save time required for performing unnecessary transmission.

(7) An apparatus controlling device is any of the devices (3) through (6), wherein the controlling section monitors the operation of the communicating section, and sends the restart signal to the communicating section if the operation of the communicating section is suspended.

In the apparatus controlling device (7), the controlling section monitors the operation of the communicating section, and sends the restart signal to the communicating section if the operation of the communicating section is suspended, thereby shortening the operation suspended period. Accordingly, the apparatus controlling device is applicable to an apparatus such as a refrigerator, in which a long-term suspension of cooling operation is prohibited, and to a security device, such as a sensor for detecting and alerting suspicious individuals, and a sensor for detecting and alerting a fire, in which even a short-term suspended operation is prohibited. Further, in this arrangement, since there is no need of additionally providing a device for monitoring the operation of the communicating section, the apparatus controlling device can be produced with a low cost.

(8) An apparatus controlling device is provided with a controlling section for controlling an apparatus by communicating a message with an external device via a communications line, and a communicating section which is provided between the controlling section and the communications line, and is adapted for performing protocol conversion of the message so as to interface with the controlling section and the communications line, wherein the controlling section includes: message receiving means to receive a first message sent from the communicating section; message creating means to create a second message; message storing means to store the first message received by the message receiving means, and the second message created by the message creating means; message processing means to read out the first message and the second message stored in the message storing means, to control the apparatus based on the readout first message, and to send the readout second message to the communicating section; identification code attaching means to record, in the message storing means, the first message after the control by the message processing section and the second message after the transmission by the message processing means, with an identification code indicating that the respective and second messages have been processed being attached thereto; discrimination database storing means to store a database describing an effective term with respect to each of contents of the first message and the second message; and message discriminating means to read out the first message and the second message from the message storing means in response to a restart signal received in the controlling section after the operation of the communicating section is suspended, and to cause the message processing means to carry out the control or the transmission with respect to the message to which the identification code has not been attached and whose effective term has not lapsed, among the readout first and second messages, by referring to the database.

In the apparatus controlling device (8), the message stored in the message storing means is read out therefrom in response to the restart signal received in the controlling section after the operation of the communicating section is suspended, and the control and the transmission are carried out with respect to the unprocessed message whose effective term has not lapsed, by referring to the database stored in the discrimination database storing means. This arrangement makes it possible to process the message which has been left unprocessed during suspension of the operation of the controlling section, and to save time required for implementing an unnecessary process with respect to the unprocessed message whose effective term has lapsed. Further, since the communicating section having the protocol converting function and sharing a function or functions among a variety of kinds of apparatus controlling devices is provided independently of the controlling section, the entire design cost regarding the various kinds of apparatus controlling devices to be used in various kinds of apparatuses can be reduced.

(9) An apparatus controlling device is the device (8), wherein the database further describes whether the second message is to be recreated after lapse of the effective term with respect to each of the contents of the second message; the message discriminating means reads out the second message from the message storing means in response to the restart signal, and causes the message creating means to recreate the second message to which the identification code has not been attached, whose effective term has lapsed and which is to be recreated, among the readout second message by referring to the database.

In the apparatus controlling device (9), the message is recreated with respect to the second message which has been left unprocessed, whose effective term has lapsed due to suspension of the operation of the controlling section and which is to be recreated by referring to the database. This arrangement makes it possible to send the recreated second message that reflects new status after restart of the controlling section, in place of sending the second message whose effective term has lapsed, and to save time required for performing unnecessary transmission.

(10) An apparatus controlling device is the device (8) or (9), wherein the communicating section monitors the operation of the controlling section, and sends the restart signal to the controlling section if the operation of the controlling section is suspended.

In the apparatus controlling device (10), the communicating section monitors the operation of the controlling section, and sends the restart signal to the controlling section if the operation of the controlling section is suspended, thereby shortening the operation suspended period. Accordingly, the apparatus controlling device is applicable to an apparatus such as a refrigerator, in which a long-term suspension of cooling suspended operation is prohibited, and to a security device, such as a sensor for detecting and alerting suspicious individuals, and a sensor for detecting and alerting a fire, in which even a short-term suspended operation is prohibited. Further, in this arrangement, since there is no need of additionally providing a device for monitoring the operation of the communicating section, the apparatus controlling device can be produced with a low cost.

(11) A home appliance comprises the message processor (1) or (2), or any one of the apparatus controlling devices (3) through (10).

Since the home appliance (11) is equipped with the aforementioned message processor or the inventive apparatus controlling device, provided is the home appliance capable of processing the message which has been left unprocessed during suspension of the operation, and saving time required performing an unnecessary process with respect to the unprocessed message whose effective term has lapsed.

(12) A program for a message processor of implementing a process by communicating a message with an external device, causes the message processor to function as: message generating means including at least one of message receiving means to receive the message from the external device, and message creating means to create the message; message storing means to store the message received or created by the message generating means; message processing means to read out the message stored in the message storing means, and to implement a process based on the message; identification code attaching means to record the message processed by the message processing means, in the message storing means, with an identification code indicating that the message has been processed being attached thereto; discrimination database storing means to store a database describing an effective term with respect to each of contents of the message; and message discriminating means to read out the message from the message storing means in response to a restart signal received in the message processor after the operation of the message processor is suspended, and to cause the message processing means to implement the process with respect to the message to which the identification code has not been attached and whose effective term has not lapsed, among the readout message, by referring to the database.

In the program (12), since the message processor functions as the aforementioned respective means, provided is the message processor capable of processing the message which has been left unprocessed during suspension of the operation of the message processor, and saving time required for performing an unnecessary process with respect to the unprocessed message whose effective term has lapsed.

(13) A microcomputer system provided with a plurality of microcomputers for communicating a message with each other, and a log memory from and into which data is readable and writable by the any one of the microcomputers, comprises: a first microcomputer, as the one of the microcomputers, including: message creating means to create the message; message sending means to send the message created by the message creating means to a second microcomputer, as the another one of the microcomputers; first message writing means to record the message sent by the message sending means in the log memory; a first database memory to store a first database describing an effective term with respect to each of contents of the message, the second microcomputer including: message processing means to process the message sent by the message sending means depending on the contents of the message; identification code attaching means to record, in the log memory, the message which has been recorded in the log memory and whose process by the message processing means has been completed, with a first identification code indicating that the message has been processed being attached thereto; a second database memory to store a second database describing an effective term with respect to each of contents of the message; and first message discriminating means to read out the message from the log memory in response to a restart signal received in the second microcomputer after the operation of the second microcomputer is suspended, and to cause the message processing means to process the message to which the first identification code has not been attached and whose effective term has not lapsed, among the readout message, by referring to the second database, the first microcomputer further including second message discriminating means to read out the message from the log memory after the second microcomputer receives the restart signal, and to cause the message creating means to recreate the message to which the first identification code has not been attached and whose effective term has lapsed, among the message read out from the log memory, by referring to the first database.

In the microcomputer system (13), the microcomputer which has received the message is so configured that the message stored in the log memory is read out therefrom in response to the restart signal received in the microcomputer after the operation of the microcomputer is suspended, and that the process is carried out with respect to the unprocessed message whose effective term has not lapsed, by referring to the database. Further, the microcomputer which has created the message is so configured that the message stored in the log memory is read out therefrom, and the new message is recreated with respect to the unprocessed message whose effective term has lapsed, by referring to the database. This arrangement makes it possible to process the message as it is which has been left unprocessed during suspension of the operation of the microcomputer and which is processable without an alteration, and also to process the recreated message that reflects new status after restart of the microcomputer in place of processing too old message. In other words, this arrangement makes it possible to perform a proper process with respect to the message which has been left unprocessed during suspension of the operation of the microcomputer.

(14) A microcomputer system is the system (13), wherein: the first database further describes whether the message is to be recreated after lapse of the effective term with respect to each of the contents of the message; and the second message discriminating means causes the message creating means to recreate the message to which the first identification code has not been attached, whose effective term has lapsed and which is to be recreated, among the message read out from the log memory by referring to the first database.

In the microcomputer system (14), the microcomputer that has created the message is operative to recreate the message with respect to the unprocessed message whose effective term has lapsed and which is to be recreated by referring to the database. This arrangement enables to save time required for performing an unnecessary process with respect to the unprocessed message whose effective term has lapsed.

(15) A microcomputer system is the system (14), wherein the second message discriminating means causes the message sending means to send the message to which the first identification code has not been attached, whose effective term has lapsed and which is not to be recreated, among the message read out from the log memory.

In the microcomputer system (15), the microcomputer that has created the message is operative to send the unprocessed message again whose effective term has lapsed and which is not to be recreated. This arrangement enables to save time required for recreating unnecessary message, and to perform a proper process, in the case where the status after the restart of the microcomputer is identical to the contents of the unprocessed message whose effective term has lapsed.

(16) A microcomputer system is the system (13), wherein the first microcomputer further includes: second message writing means records the message created by the message creating means in the log memory; and the first message writing means to record, in the log memory, the message which has been recorded by the second message writing means and whose transmission by the message sending means has been completed, with a second identification code indicating that the message has been processed being attached thereto, the first microcomputer further includes: third message discriminating means to read out the message from the log memory in response to a restart signal received in the first microcomputer after the operation of the first microcomputer is suspended, to cause the message sending means to send the message to which the second identification code has not been attached and whose effective term has not lapsed, among the message read out from the log memory, by referring to the first database, and to cause the message creating means to recreate the message to which the second identification code has not been attached and whose effective term has lapsed.

In the microcomputer system (16), the microcomputer that has created the message is operative to read out and send the message stored in the log memory in response to the restart signal received in the microcomputer after the operation of the microcomputer is suspended, to send the unprocessed message whose effective term has not lapsed, by referring to the database, and to create the new message with respect to the unprocessed message whose effective term has lapsed. This arrangement enables the message receiving microcomputer to process the message as it is which has been left unprocessed during suspension of the operation of the message creating microcomputer and which is processable without an alteration, and to process the recreated message that reflects new status after restart of the microcomputer in place of processing too old message. In other words, this arrangement enables the message receiving microcomputer to perform a proper process with respect to the unprocessed message during suspension of the operation of the message creating microcomputer.

(17) A microcomputer system is the system (16), wherein: the first database further describes whether the message is to be recreated after lapse of the effective term with respect to each of the contents of the message; and the third message discriminating means causes the message creating means to recreate the message to which the second identification code has not been attached, whose effective term has lapsed and which is to be recreated, among the message read out from the log memory by referring to the first database.

In the microcomputer system (17), the microcomputer that has created the message is operative to recreate the new message with respect to the unprocessed message whose effective term has lapsed and which is to be recreated by referring to the database. This arrangement enables to save time required for the message receiving microcomputer to perform an unnecessary process with respect to the unprocessed message whose effective term has lapsed.

(18) A microcomputer system is the system (17), wherein the third message discriminating means causes the message sending means to send the message to which the second identification code has not been attached, whose effective term has lapsed and which is not to be recreated, among the message read out from the log memory.

In the microcomputer system (18), the microcomputer that has created the message is operative to send the unprocessed message again whose effective term has lapsed and which is not to be recreated. This arrangement enables to save time required for recreating the unnecessary message, and to cause the message receiving microcomputer to perform a proper process, in the case where the status after the restart of the message creating microcomputer is identical to the contents of the unprocessed message whose effective term has lapsed.

(19) A microcomputer system is any of the systems (13) through (18), wherein: the microcomputers include a master microcomputer, and a plurality of sub microcomputers for communicating the message with each other, communication of the message between the sub microcomputers being conducted via the master microcomputer; the first. microcomputer is the one of the sub microcomputers; and the second microcomputer is the master microcomputer.

In the microcomputer system (19) including the master microcomputer and the sub microcomputers, the message which has been left unprocessed during suspension of the operation of the master microcomputer can be processed appropriately.

(20) A microcomputer system is any of the systems (13) through (18), wherein: the microcomputers include a master microcomputer, and a plurality of sub microcomputers for communicating the message with each other, communication of the message between the sub microcomputers being conducted via the master microcomputer; the first microcomputer is the one of the sub microcomputers; and the second microcomputer is the another one of the sub microcomputers.

In the microcomputer system (20) including the master microcomputer and the sub microcomputers, the message which has been left unprocessed during suspension of one of the operation of the sub microcomputers can be processed appropriately.

(21) A microcomputer system is the system (19) or (20), wherein at least one of the sub microcomputers monitors the operation of the master microcomputer, and sends the restart signal to the master microcomputer if the operation of the master microcomputer is suspended.

In the microcomputer system (21), the sub microcomputer monitors the operation of the master microcomputer, and sends the restart signal to the master microcomputer if the operation of the master microcomputer is suspended. This arrangement enables to shorten the operation suspended period, and to eliminate additionally providing a device for monitoring the operation of the master microcomputer, thereby producing the microcomputer system with a low cost.

(22) A microcomputer system is any of the systems (19) through (21), wherein the master microcomputer monitors the operations of the sub microcomputers, and, if the operation of the one of the sub microcomputers is suspended, sends the restart signal to the operation-suspended sub microcomputer.

In the microcomputer system (22), the master microcomputer monitors the operations of the respective sub microcomputers, and sends the restart signal to the operation-suspended sub microcomputer if the operation of the sub microcomputer is suspended. This arrangement enables to shorten the operation suspended period, and to eliminate additionally providing a device for monitoring the operation of the sub microcomputers, thereby producing the microcomputer system with a low cost.

(23) A home appliance comprises the any of microcomputer systems (13) through (22).

Since the home appliance (23) is equipped with the aforementioned microcomputer system, provided is the home appliance capable of processing the message as it is which has been left unprocessed during suspension of the operation of the microcomputer and which is processable without an alteration, and processing the recreated message that reflects new status after restart of the microcomputer in place of processing too old message.

(24) A program for a microcomputer system provided with a plurality of microcomputers for communicating a message with each other, and a log memory from and into which data is readable and writable by the any one of the microcomputers, causes a first microcomputer, as the one of the microcomputers, to function as: message creating means to create the message; message sending means to send the message created by the message creating means to a second microcomputer, as the another one of the microcomputers; first message writing means to record the message sent by the message sending mean in the log memory; and a first database memory storing a first database describing an effective term with respect to each of contents of the message. The program causes the second microcomputer to function as: message processing means to process the message sent by the message sending means depending on the contents of the message; identification code attaching means to record, in the log memory, the message which has been recorded in the log memory and whose process by the message processing means has been completed, with a first identification code indicating that the message has been processed being attached thereto; a second database memory storing a second database describing an effective term with respect to each of the contents of the message; and first message discriminating means to read out the message from the log memory in response to a restart signal received in the second microcomputer after the operation of the second microcomputer is suspended, and to cause the message processing means to process the message to which the first identification code has not been attached and whose effective term has not lapsed, among the readout message, by referring to the second database. The program further causes the first microcomputer to function as second message discriminating means to read out the message from the log memory after the second microcomputer receives the restart signal, and to cause the message creating means to recreate the message to which the first identification code has not been attached and whose effective term has lapsed, among the readout message, by referring to the first database.

In the program (24), since the first microcomputer and the second microcomputer function as the aforementioned respective means, provided is the useful microcomputer system capable of processing the message as it is which has been left unprocessed during suspension of the operation of the microcomputer and which is processable without an alteration, and processing the recreated message that reflects the status after restart of the microcomputer in place of processing too old message.

Although the present invention has been fully described by way of example with reference to the accompanying drawings, it is to be understood that various changes and modifications will be apparent to those skilled in the art. Therefore, unless otherwise such changes and modifications depart from the scope of the present invention hereinafter defined, they should be construed as being included therein.

A message 6 received or created in a message generating section 10 is stored in a message memory 3. Upon lapse of a stand-by time, a message processing section 15 reads out the message 6 from the message memory 3 for transmission to an external device or for an internal process. When the transmission or the internal process is completed, an ID code attaching section 18 attaches a code indicating that the message 6 has been processed, to the message 6. A database stored in a discrimination database memory 4 describes an effective term with respect to each of contents of the message 6. In response to receiving a restart signal 8 after the operation of an apparatus controlling device 100 is suspended, a message discriminating section 20 causes the message processing section 15 to process the message which has not been processed and whose effective term has not lapsed, among the message(s) 6 stored in the message memory 3. With this arrangement, a proper process is executable with respect to the message which has been left unprocessed by the suspension of the operation of the apparatus controlling device 100, after the operation of the apparatus controlling device 100 is resumed.

## Claims

1. A message processor for implementing a process by communicating a message with an external device, the message processor comprising:
message generating means including at least one of message receiving means to receive the message from the external device, and message creating means to create the message;
message storing means to store the message received or created by the message generating means;
message processing means to read out the message stored in the message storing means and to implement a process based on the message;
identification code attaching means to record, in the message storing means, the message processed by the message processing means with an identification code indicating that the message has been processed being attached thereto;
discrimination database storing means to store a database describing an effective term with respect to each of contents of the message; and
message discriminating means to read out the message from the message storing means in response to a restart signal received in the message processor after the operation of the message processor is suspended, and to cause the message processing means to implement the process with respect to the message to which the identification code has not been attached and whose effective term has not lapsed, among the readout message, by referring to the database.

2. The message processor according to Claim 1, wherein:
the message generating means includes the message creating means;
the database further describes whether the message is to be recreated after lapse of the effective term with respect to each of the contents of the message created by the message creating means; and
the message discriminating means causes the message creating means to recreate the message to which the identification code has not been attached, whose effective term has lapsed and which is to be recreated, among the message read out from the message storing means in response to the restart signal by referring to the database.

3. An apparatus controlling device provided with a controlling section for controlling an apparatus by communicating a message with an external device via a communications line, and a communicating section which is provided between the controlling section and the communications line, and is adapted for performing protocol conversion of the message so as to interface with the controlling section and the communications line, wherein
the communicating section includes:
message receiving means to receive a first message sent through the communications line and a second message sent from the controlling section;
message storing means to store the first message and the second message received by the message receiving means;
message processing means to read out the first message and the second message stored in the message storing means, to send the readout first message to the controlling section, and to send the readout second message to the communications line;
identification code attaching means to record, in the message storing means, the first message and the second message after the transmission by the message processing means, with the identification code indicating that the respective first and second messages have been processed being attached thereto;
discrimination database storing means to store a database describing an effective term with respect to each of contents of the first message and the second message; and
message discriminating means to read out the first message and the second message from the message storing means in response to a restart signal received in the communicating section after the operation of the communicating section is suspended, and to cause the message processing means to send the message to which the identification code has not been attached and whose effective term has not lapsed, among the readout first and second messages, by referring to the database.

4. The apparatus controlling device according to Claim 3, wherein:
the communicating section further includes message creating means to create a third message;
the message storing means stores the third message created by the message creating means;
the message processing means reads out the third message stored in the message storing means, sends the readout third message to the communications line, sends, to the controlling section, the readout first message except for one containing a data request to the controlling section, and causes the message creating means to create the third message responding to the first message containing the data request;
identification code attaching means records, in the message storing means, the third message after the transmission by the message processing means, with the identification code indicating that the third message has been processed being attached thereto;
the database describes an effective term with respect to each of contents of the third message;
the message discriminating means reads out the third message from the message storing means in response to the restart signal, and causes the message processing means to send the message to which the identification code has not been attached and whose effective term has not lapsed, among the readout third message, by referring to the database; and
the controlling section sends, to the communicating section, data required for the message creating section to create the third message responding to the data request contained by the first message.

5. The apparatus controlling device according to Claim 4, wherein
the database further describes whether the third message is to be recreated after lapse of the effective term with respect to each of the contents of the third message;
the message discriminating means causes the message creating means to recreate the third message to which the identification code has not been attached, whose effective term has lapsed, and which is to be recreated, among the third message read out from the message storing means in response to the restart signal by referring to the database; and
the controlling section sends, to the communicating section, data required for the message creating section to recreate the third message after the operation of the communicating section is resumed in response to the restart signal.

6. The apparatus controlling device according to Claim 5, wherein
the database further describes whether the second message is to be recreated after lapse of the effective term with respect to each of the contents of the second message;
message discriminating means causes the message creating means to recreate the second message to which the identification code has not been attached, whose effective term has lapsed and which is to be recreated, as the third message, among the second message read out from the message storing means in response to the restart signal by referring to the database; and
the controlling section sends, to the communicating section, data required for the message creating section to recreate the second message as the third message after the operation of the communicating section is resumed in response to the restart signal.

7. The apparatus controlling device according to any one of Claims 3 through 6, wherein the controlling section monitors the operation of the communicating section, and sends the restart signal to the communicating section if the operation of the communicating section is suspended.

8. An apparatus controlling device provided with a controlling section for controlling an apparatus by communicating a message with an external device via a communications line, and a communicating section which is provided between the controlling section and the communications line, and is adapted for performing protocol conversion of the message so as to interface with the controlling section and the communications line, wherein
the controlling section includes:
message receiving means to receive a first message sent from the communicating section;
message creating means to create a second message;
message storing means to store the first message received by the message receiving means, and the second message created by the message creating means;
message processing means to read out the first message and the second message stored in the message storing means, to control the apparatus based on the readout first message, and to send the readout second message to the communicating section;
identification code attaching means to record, in the message storing means, the first message after the control by the message processing section and the second message after the transmission by the message processing means, with an identification code indicating that the respective and second messages have been processed being attached thereto;
discrimination database storing means to store a database describing an effective term with respect to each of contents of the first message and the second message; and
message discriminating means to read out the first message and the second message from the message storing means in response to a restart signal received in the controlling section after the operation of the communicating section is suspended, and to cause the message processing means to carry out the control or the transmission with respect to the message to which the identification code has not been attached and whose effective term has not lapsed, among the readout first and second messages, by referring to the database.

9. The apparatus controlling device according to Claim 8, wherein
the database further describes whether the second message is to be recreated after lapse of the effective term with respect to each of the contents of the second message;
the message discriminating means reads out the second message from the message storing means in response to the restart signal, and causes the message creating means to recreate the second message to which the identification code has not been attached, whose effective term has lapsed and which is to be recreated, among the readout second message by referring to the database.

10. The apparatus controlling device according to Claim 8 or 9, wherein the communicating section monitors the operation of the controlling section, and sends the restart signal to the controlling section if the operation of the controlling section is suspended.

11. A home appliance comprising the message processor of Claim 1 or 2, or the apparatus controlling device of any one of claims 3 through 10.

12. A program for a message processor of implementing a process by communicating a message with an external device, the program causing the message processor to function as:
message generating means including at least one of message receiving means to receive the message from the external device, and message creating means to create the message;
message storing means to store the message received or created by the message generating means;
message processing means to read out the message stored in the message storing means, and to implement a process based on the message;
identification code attaching means to record the message processed by the message processing means, in the message storing means, with an identification code indicating that the message has been processed being attached thereto;
discrimination database storing means to store a database describing an effective term with respect to each of contents of the message; and
message discriminating means to read out the message from the message storing means in response to a restart signal received in the message processor after the operation of the message processor is suspended, and to cause the message processing means to implement the process with respect to the message to which the identification code has not been attached and whose effective term has not lapsed, among the readout message, by referring to the database.

13. A microcomputer system provided with a plurality of microcomputers for communicating a message with each other, and a log memory from and into which data is readable and writable by the any one of the microcomputers, the microcomputer system comprising:
a first microcomputer, as the one of the microcomputers, including:
message creating means to create the message;
message sending means to send the message created by the message creating means to a second microcomputer, as the another one of the microcomputers;
first message writing means to record the message sent by the message sending means in the log memory;
a first database memory to store a first database describing an effective term with respect to each of contents of the message,
the second microcomputer including:
message processing means to process the message sent by the message sending means depending on the contents of the message;
identification code attaching means to record, in the log memory, the message which has been recorded in the log memory and whose process by the message processing means has been completed, with a first identification code indicating that the message has been processed being attached thereto;
a second database memory to store a second database describing an effective term with respect to each of contents of the message; and
first message discriminating means to read out the message from the log memory in response to a restart signal received in the second microcomputer after the operation of the second microcomputer is suspended, and to cause the message processing means to process the message to which the first identification code has not been attached and whose effective term has not lapsed, among the readout message, by referring to the second database,
the first microcomputer further including second message discriminating means to read out the message from the log memory after the second microcomputer receives the restart signal, and to cause the message creating means to recreate the message to which the first identification code has not been attached and whose effective term has lapsed, among the message read out from the log memory, by referring to the first database.

14. The microcomputer system according to Claim 13, wherein:
the first database further describes whether the message is to be recreated after lapse of the effective term with respect to each of the contents of the message; and
the second message discriminating means causes the message creating means to recreate the message to which the first identification code has not been attached, whose effective term has lapsed and which is to be recreated, among the message read out from the log memory by referring to the first database.

15. The microcomputer system according to Claim 14, wherein the second message discriminating means causes the message sending means to send the message to which the first identification code has not been attached, whose effective term has lapsed and which is not to be recreated, among the message read out from the log memory.

16. The microcomputer system according to Claim 13, wherein
the first microcomputer further includes:
second message writing means records the message created by the message creating means in the log memory; and
the first message writing means to record, in the log memory, the message which has been recorded by the second message writing means and whose transmission by the message sending means has been completed, with a second identification code indicating that the message has been processed being attached thereto,
the first microcomputer further includes:
third message discriminating means to read out the message from the log memory in response to a restart signal received in the first microcomputer after the operation of the first microcomputer is suspended, to cause the message sending means to send the message to which the second identification code has not been attached and whose effective term has not lapsed, among the message read out from the log memory, by referring to the first database, and to cause the message creating means to recreate the message to which the second identification code has not been attached and whose effective term has lapsed.

17. The microcomputer system according to Claim 16, wherein:
the first database further describes whether the message is to be recreated after lapse of the effective term with respect to each of the contents of the message; and
the third message discriminating means causes the message creating means to recreate the message to which the second identification code has not been attached, whose effective term has lapsed and which is to be recreated, among the message read out from the log memory by referring to the first database.

18. The microcomputer system according to Claim 17, wherein the third message discriminating means causes the message sending means to send the message to which the second identification code has not been attached, whose effective term has lapsed and which is not to be recreated, among the message read out from the log memory.

19. The microcomputer system according to any one of Claims 13 through 18, wherein:
the microcomputers include a master microcomputer, and a plurality of sub microcomputers for communicating the message with each other, communication of the message between the sub microcomputers being conducted via the master microcomputer;
the first microcomputer is the one of the sub microcomputers; and
the second microcomputer is the master microcomputer.

20. The microcomputer system according to any one of Claims 13 through 18, wherein:
the microcomputers include a master microcomputer, and a plurality of sub microcomputers for communicating the message with each other, communication of the message between the sub microcomputers being conducted via the master microcomputer;
the first microcomputer is the one of the sub microcomputers; and
the second microcomputer is the another one of the sub microcomputers.

21. The microcomputer system according to Claim 19 or 20, wherein at least one of the sub microcomputers monitors the operation of the master microcomputer, and sends the restart signal to the master microcomputer if the operation of the master microcomputer is suspended.

22. The microcomputer system according to any one of Claims 19 through 21, wherein the master microcomputer monitors the operations of the sub microcomputers, and, if the operation of the one of the sub microcomputers is suspended, sends the restart signal to the operation-suspended sub microcomputer.

23. A home appliance comprising the microcomputer system according to any one of Claims 13 through 22.

24. A program for a microcomputer system provided with a plurality of microcomputers for communicating a message with each other, and a log memory from and into which data is readable and writable by the any one of the microcomputers, wherein:
the program causes a first microcomputer, as the one of the microcomputers, to function as:
message creating means to create the message;
message sending means to send the message created by the message creating means to a second microcomputer, as the another one of the microcomputers;
first message writing means to record the message sent by the message sending mean in the log memory; and
a first database memory storing a first database describing an effective term with respect to each of contents of the message;
the program causes the second microcomputer to function as:
message processing means to process the message sent by the message sending means depending on the contents of the message;
identification code attaching means to record, in the log memory, the message which has been recorded in the log memory and whose process by the message processing means has been completed, with a first identification code indicating that the message has been processed being attached thereto;
a second database memory storing a second database describing an effective term with respect to each of the contents of the message; and
first message discriminating means to read out the message from the log memory in response to a restart signal received in the second microcomputer after the operation of the second microcomputer is suspended, and to cause the message processing means to process the message to which the first identification code has not been attached and whose effective term has not lapsed, among the readout message, by referring to the second database,
the program further causes the first microcomputer to function as second message discriminating means to read out the message from the log memory after the second microcomputer receives the restart signal, and to cause the message creating means to recreate the message to which the first identification code has not been attached and whose effective term has lapsed, among the readout message, by referring to the first database.

25. A program product comprising the program according to Claim 12 or 24, and a holding medium for holding the program therein.

26. The program product according to Claim 25, wherein the holding medium is at least one of a storage medium and a transmission medium.
